(19) Europäisches Patentamt
European Patent Office
Office européen des brevets

(11) **EP 4 459 513 A1**

(12) **EUROPEAN PATENT APPLICATION**
published in accordance with Art. 153(4) EPC

(43) Date of publication:
06.11.2024 Bulletin 2024/45

(21) Application number: 21969906.3

(22) Date of filing: 27.12.2021

(51) International Patent Classification (IPC):
*G06N 10/00* (2022.01)

(52) Cooperative Patent Classification (CPC):
G06N 10/40; G06F 30/398; G06N 10/00

(86) International application number:
PCT/JP2021/048573

(87) International publication number:
WO 2023/127022 (06.07.2023 Gazette 2023/27)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: FUJITSU LIMITED
Kawasaki-shi, Kanagawa 211-8588 (JP)

(72) Inventor: ISHII, Masatoshi
Kawasaki-shi, Kanagawa 211-8588 (JP)

(74) Representative: Hoffmann Eitle
Patent- und Rechtsanwälte PartmbB
Arabellastraße 30
81925 München (DE)

(54) **QUANTUM CIRCUIT DESIGN PROGRAM, QUANTUM CIRCUIT DESIGN METHOD, AND QUANTUM CIRCUIT DESIGN DEVICE**

(57)     An error in quantum calculation is reduced.

A quantum circuit design device (10) detects a first element (1a) and a second element (1b) that indicate a predetermined operation on a plurality of first qubits and that are included in a first quantum circuit (1) that is a quantum circuit that includes a plurality of elements and that indicates operation order on each of a plurality of qubits by arrangement of each of the plurality of elements. Then, the quantum circuit design device (10) generates a second quantum circuit obtained by converting the first element (1a) into a first equivalent circuit (2) for ion operation that corresponds to the plurality of qubits in the first quantum circuit (1) and converting the second element (1b) into a second equivalent circuit (3) arranged by symmetrically moving elements of the first equivalent circuit (2) in an arrangement direction of the plurality of first qubits.

FIG. 1

2a TO 2e, 3a TO 3e: TWO-QUBIT GATE (XX GATE)

EP 4 459 513 A1

## Description

TECHNICAL FIELD

The present invention relates to a quantum circuit design program, a quantum circuit design method, and a quantum circuit design device.

BACKGROUND ART

There is a quantum computer that executes calculation faster than a classical computer using quantum properties. A quantum computer based on a quantum gate system performs quantum calculation by performing a gate operation on qubits in order indicated in a quantum circuit.

Examples of quantum algorithm executed by the quantum computer based on the quantum gate system include Grover's algorithm for searching data. For example, in a case where one piece of data is searched for from N pieces of data (N is a natural number), an average number of arithmetic operations by a classical computer is N/2, whereas the data may be searched for in $N^{1/2}$ arithmetic operations according to the Grover's algorithm.

As a technology related to a quantum computer, for example, automated methods for optimizing quantum circuits of a size and type expected in quantum calculation have been proposed. Furthermore, a technology related to a random interference gate that performs a random interference operation on a vector of an input set according to Grover's quantum search algorithm has also been proposed. Moreover, a technology of compilation of quantum algorithm into optimized physical-level circuits executable in a quantum information processing experiment using atomic ions has also been proposed.

CITATION LIST

PATENT DOCUMENT

Patent Document 1: Japanese National Publication of International Patent Application No. 2021-503116
Patent Document 2: Japanese National Publication of International Patent Application No. 2003-526855

NON-PATENT DOCUMENT

Non-Patent Document 1: Dmitri Maslov, "Basic circuit compilation techniques for an ion-trap quantum Machine" New Journal of Physics, Volume 19, February 2017

SUMMARY OF INVENTION

TECHNICAL PROBLEM

A qubit is implemented by using, for example, superconductivity, an ion trap, or the like. Furthermore, in a gate operation on the qubit, for example, a quantum computer irradiates the qubit with a microwave. An error may occur in quantum calculation due to noise included in such a gate operation on the qubit.

In one aspect, an object of the present invention is to reduce an error in quantum calculation.

SOLUTION TO PROBLEM

In one proposal, a quantum circuit design program that causes a computer to execute the following processing is provided.

A computer detects, from a first quantum circuit that is a quantum circuit that includes a plurality of elements and that indicates operation order on each of a plurality of qubits included in a quantum computer by arrangement of each of the plurality of elements in the quantum circuit, a first element that indicates a predetermined operation on a plurality of first qubits among the plurality of qubits and a second element that indicates the predetermined operation on the plurality of first qubits. Then, the computer generates a second quantum circuit obtained by converting the first element of the first quantum circuit into a first equivalent circuit for ion operation that corresponds to the plurality of first qubits and converting the second element into a second equivalent circuit arranged by symmetrically moving elements of the first equivalent circuit in an arrangement direction of the plurality of first qubits.

ADVANTAGEOUS EFFECTS OF INVENTION

According to one aspect, an error in quantum calculation may be reduced.

The object described above and other objects, features, and advantages of the present invention will become clear from the following description related to the appended drawings, which represent preferred embodiments as examples of the present invention.

BRIEF DESCRIPTION OF DRAWINGS

FIG. 1 is a diagram illustrating an example of a quantum circuit design method according to a first embodiment.
FIG. 2 is a diagram illustrating an example of a system configuration of a second embodiment.
FIG. 3 is a diagram illustrating a configuration example of hardware of a control computer.
FIG. 4 is a diagram illustrating an example of a change in probability amplitude according to Grover's algorithm.
FIG. 5 is a diagram illustrating an example of a quantum circuit that executes the Grover's algorithm with three qubits.
FIG. 6 is a diagram illustrating an example of an equivalent circuit of a CCZ gate for a superconducting quantum computer.
FIG. 7 is a diagram illustrating an example of an equivalent circuit of a CX gate using an XX gate.
FIG. 8 is a diagram illustrating a first example of an equivalent circuit of the CCZ gate using the XX gate.
FIG. 9 is a diagram illustrating an example of a relationship between a quantum calculation result and noise in a case where CCZ gates are replaced with the same equivalent circuit.
FIG. 10 is a block diagram illustrating a functional example of the control computer.
FIG. 11 is a diagram illustrating an example of conversion information.
FIG. 12 is a diagram illustrating an example of a quantum circuit after conversion in a case where quantum calculation is performed by the superconducting quantum computer.
FIG. 13 is a diagram illustrating a second example of the equivalent circuit of the CCZ gate using the XX gate.
FIG. 14 is a diagram illustrating an example of a quantum circuit after conversion in a case where quantum calculation is performed by an ion trap quantum computer.
FIG. 15 is a diagram illustrating an example of conversion processing of a CCX gate.
FIG. 16 is a diagram illustrating an example of conversion processing of a CnNOT gate.
FIG. 17 is a diagram illustrating an example of an equivalent circuit of the CnNOT gate.
FIG. 18 is a flowchart illustrating an example of a procedure of quantum circuit conversion processing.
FIG. 19 is a diagram (part 1) illustrating an example of a relationship between a quantum calculation result and noise.
FIG. 20 is a diagram illustrating a third example of the equivalent circuit of the CCZ gate using the XX gate.
FIG. 21 is a diagram illustrating a fourth example of the equivalent circuit of the CCZ gate using the XX gate.
FIG. 22 is a diagram illustrating a fifth example of the equivalent circuit of the CCZ gate using the XX gate.
FIG. 23 is a diagram illustrating a sixth example of the equivalent circuit of the CCZ gate using the XX gate.
FIG. 24 is a diagram (part 2) illustrating an example of the relationship between the quantum calculation result and the noise.
FIG. 25 is a diagram (part 3) illustrating an example of the relationship between the quantum calculation result and the noise.
FIG. 26 is a diagram (part 4) illustrating an example of the relationship between the quantum calculation result and the noise.
FIG. 27 is a diagram (part 5) illustrating an example of the relationship between the quantum calculation result and the noise.
FIG. 28 is a diagram illustrating an example of a quantum circuit that executes the Grover's algorithm with six qubits.
FIG. 29 is a diagram illustrating a conversion example of the CCX gate in an equivalent circuit of a C5NOT gate.
FIG. 30 is a diagram (part 6) illustrating an example of the relationship between the quantum calculation result and the noise.
FIG. 31 is a diagram (part 7) illustrating an example of the relationship between the quantum calculation result and the noise.

DESCRIPTION OF EMBODIMENTS

Hereinafter, the present embodiments will be described with reference to the drawings. Note that each of the embodiments may be implemented in combination with a plurality of embodiments as long as no contradiction arises.

[First Embodiment]

First, a first embodiment will be described. The first embodiment is a quantum circuit design method capable of reducing an error in quantum calculation in an ion trap quantum computer.

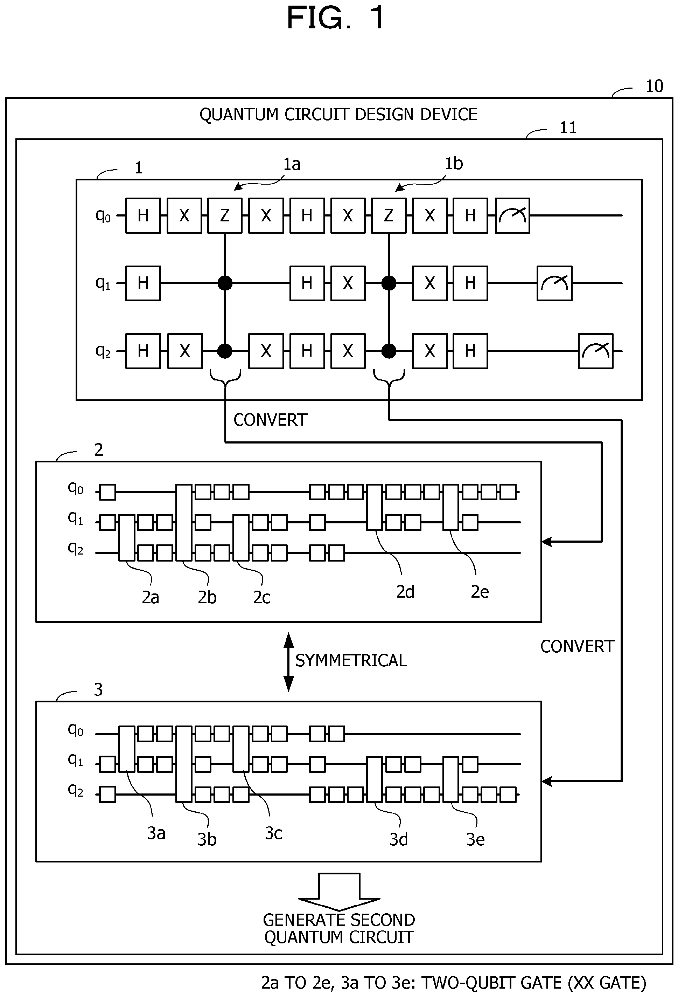

FIG. 1 is a diagram illustrating an example of the quantum circuit design method according to the first embodiment. In FIG. 1, a quantum circuit design device 10 that performs the quantum circuit design method capable of reducing an error in quantum calculation is illustrated. The quantum circuit design device 10 may perform the quantum circuit design method capable of reducing an error in quantum calculation by, for example, executing a quantum circuit design program.

The quantum circuit design device 10 includes a processing unit 11. The processing unit 11 is, for example, a processor or an arithmetic circuit included in the quantum circuit design device 10. The processing unit 11 generates a second quantum circuit obtained by converting elements included in a first quantum circuit 1. The first quantum circuit 1 is a quantum circuit including a plurality of elements, and indicates operation order for each of qubits $q_0$, $q_1$, and $q_2$ by arrangement of each of the plurality of elements in the quantum circuit. For example, the first quantum circuit 1 has lines corresponding to the respective qubits $q_0$, $q_1$, and $q_2$. In the first quantum circuit 1, the line corresponding to the qubit $q_0$, the line corresponding to the qubit $q_1$, and the line corresponding to the qubit $q_2$ are arranged in order from the top. On each line included in the first quantum circuit 1, an element indicating an operation on a quantum state of the corresponding qubit is arranged. In the first quantum circuit 1, an element indicating an operation performed earlier is arranged on the left.

Examples of the elements arranged in the first quantum circuit 1 include an H gate, an X gate, a CCZ gate, measurement, and the like. Here, the CCZ gate is arranged by setting two control bits and one target bit. The CCZ gate indicates that, in a case where the two control bits are "1", a Z gate is acted (phase is inverted) on the one target bit. Note that the CCZ gate is equivalent no matter which combination of the two control bits and the one target bit is set from the three qubits.

The processing unit 11 detects a first element 1a indicating a predetermined operation and a second element 1b indicating the predetermined operation on a plurality of first qubits among the qubits $q_0$, $q_1$, and $q_2$ included in the first quantum circuit 1. Here, the predetermined operation is an operation of inverting a phase of one target bit among the qubits $q_0$, $q_1$, and $q_2$ according to two control bits among the three qubits $q_0$, $q_1$, and $q_2$. That is, the processing unit 11 detects two CCZ gates for the qubits $q_0$, $q_1$, and $q_2$.

Then, the processing unit 11 generates the second quantum circuit obtained by converting the first element 1a into a first equivalent circuit 2 in the first quantum circuit 1 and converting the second element 1b into a second equivalent circuit 3 arranged by symmetrically moving elements of the first equivalent circuit 2 in an arrangement direction of the plurality of first qubits. Quantum gates included in the first equivalent circuit 2 are two-qubit gates 2a to 2e or a one-qubit gate. Similarly, quantum gates included in the second equivalent circuit 3 are two-qubit gates 3a to 3e or a one-qubit gate. Since the number of qubits to be operated of each quantum gate in the first equivalent circuit 2 and the second equivalent circuit 3 is equal to or less than two, the qubits may be operated according to each of the first equivalent circuit 2 and the second equivalent circuit 3.

The first equivalent circuit 2 is an equivalent circuit for ion operation corresponding to qubits in the ion trap quantum computer. For the ion operation corresponding to the qubits in the ion trap quantum computer, an XX gate is used. The XX gate is a gate indicating an operation of simultaneously rotating states of two qubits by a predetermined angle around an X axis.

For example, the processing unit 11 converts the CCZ gate for the qubits $q_0$, $q_1$, and $q_2$ included in the first quantum circuit 1 into the first equivalent circuit 2 that is a combination of the XX gate, an $R_x$ gate, an $R_y$ gate, an $R_z$ gate, a T gate, and a $T^\dagger$ gate and is equivalent to the CCZ gate. The $R_x$ gate is a gate indicating an operation of causing rotation by an optional angle around the X axis. The $R_y$ gate is a gate indicating an operation of causing rotation by an optional angle around a Y axis. The $R_z$ gate is a gate indicating an operation of causing rotation by an optional angle around a Z axis. The T gate is a gate indicating an operation of causing rotation of 45 degrees around the Z axis. The $T^\dagger$ gate is a gate indicating a rotation operation in which a rotation direction of the T gate is set to an opposite direction.

Furthermore, the processing unit 11 converts the CCZ gate for the qubits $q_0$, $q_1$, and $q_2$, which is included in the first quantum circuit 1 and is different from the CCZ gate converted into the first equivalent circuit 2, into the second equivalent circuit 3 arranged by symmetrically moving the elements of the first equivalent circuit 2 with the line corresponding to the qubit $q_1$ as an axis.

As described above, the processing unit 11 detects the gates (the first element 1a and the second element 1b) indicating the predetermined operation on the plurality of first qubits among the qubits $q_0$, $q_1$, and $q_2$ included in the first quantum circuit 1 indicating the operation order on each of the qubits $q_0$, $q_1$, and $q_2$ by the arrangement of the elements. Then, the processing unit 11 generates the second quantum circuit obtained by converting the first element 1a into the first equivalent circuit 2 in the first quantum circuit 1 and converting the second element 1b into the second equivalent circuit 3 arranged by symmetrically moving the elements of the first equivalent circuit 2 in the arrangement direction of the plurality of first qubits.

In quantum calculation, an error may occur in each qubit due to noise included in a gate operation on a qubit. Therefore, when the number of gate operations for each qubit is biased, an error is likely to occur in a qubit having a large number of gate operations. In the second quantum circuit, since the second equivalent circuit 3 is arranged by symmetrically moving the elements of the first equivalent circuit 2 in the arrangement direction of the plurality of first qubits, the number of gate operations for each qubit is less biased. Therefore, the ion trap quantum computer operates qubits according to the second quantum circuit, so that a bias of the qubits affected by noise may be reduced. Therefore, the quantum circuit design device 10 may reduce an error in the quantum calculation.

Furthermore, the predetermined operation is the operation of inverting, according to two control bits among three first qubits, a phase of one target bit among the first qubits. The predetermined operation is, for example, the CCZ gate. As a result, the quantum circuit design device 10 may reduce an error in quantum calculation including the CCZ gate.

Note that the processing unit 11 may convert a third element that inverts, according to two control bits among the first qubits, a bit of one target bit among the first qubits into a third equivalent circuit including the predetermined operation. The third element is, for example, a CCX gate. As a result, the quantum circuit design device 10 may reduce an error in quantum calculation including the CCX gate.

Furthermore, the processing unit 11 may convert a fourth element that inverts, according to equal to or more than three control bits of second qubits including the first qubits, a bit of one target bit of the second qubits into a fourth equivalent circuit including the third element. The fourth element is, for example, a CnNOT gate. As a result, the quantum circuit design device 10 may reduce an error in the quantum calculation including the CnNOT gate.

[Second Embodiment]

Next, a second embodiment will be described. The second embodiment is a system in which an ion trap quantum computer performs quantum calculation according to a quantum circuit.

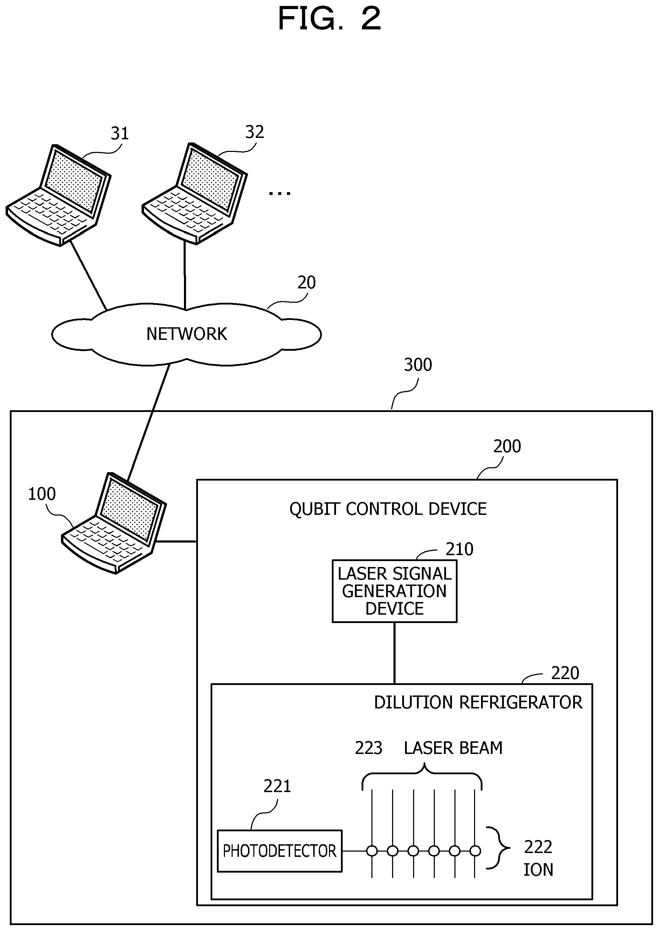

FIG. 2 is a diagram illustrating an example of a system configuration of the second embodiment. A quantum computer 300 is the ion trap quantum computer. The ion trap quantum computer 300 is one of quantum computers based on a gate system. The quantum computer 300 includes a control computer 100 and a qubit control device 200. To the control computer 100, terminal devices 31, 32, ... are coupled via a network 20. The terminal devices 31, 32, ... are computers used by users who request quantum calculation by the quantum computer 300. The control computer 100 receives quantum circuits from the terminal devices 31, 32, .... The quantum circuit indicates order of operations on qubits by arrangement of elements such as gates. The qubit is a bit capable of expressing a superposed state of a state of "0" and a state of "1".

The control computer 100 instructs the qubit control device 200 to control qubits according to the quantum circuits received from the terminal devices 31, 32, .... Furthermore, the control computer 100 acquires a measurement result of each qubit from the qubit control device 200.

The qubit control device 200 includes a plurality of qubits and a device for operating each of the plurality of qubits. For example, the qubit control device 200 includes a laser signal generation device 210 and a dilution refrigerator 220. The laser signal generation device 210 outputs a plurality of laser beams 223 according to an instruction from the control computer 100. The dilution refrigerator 220 confines a plurality of ions (charged particles) 222 using an electromagnetic field in a free space. The dilution refrigerator 220 maintains a state where the plurality of ions 222 is cooled to a very low temperature. Each of the plurality of ions 222 is irradiated with the laser beam 223 output from the laser signal generation device 210. A state of each of the plurality of ions 222 is observed by a photodetector 221 provided in the dilution refrigerator 220.

Each of the plurality of ions 222 corresponds to a qubit, and the state of each of the plurality of ions 222 represents a state of the corresponding qubit. When the state of each of the plurality of qubits is measured, the qubit control device 200 transmits a measurement result to the control computer 100.

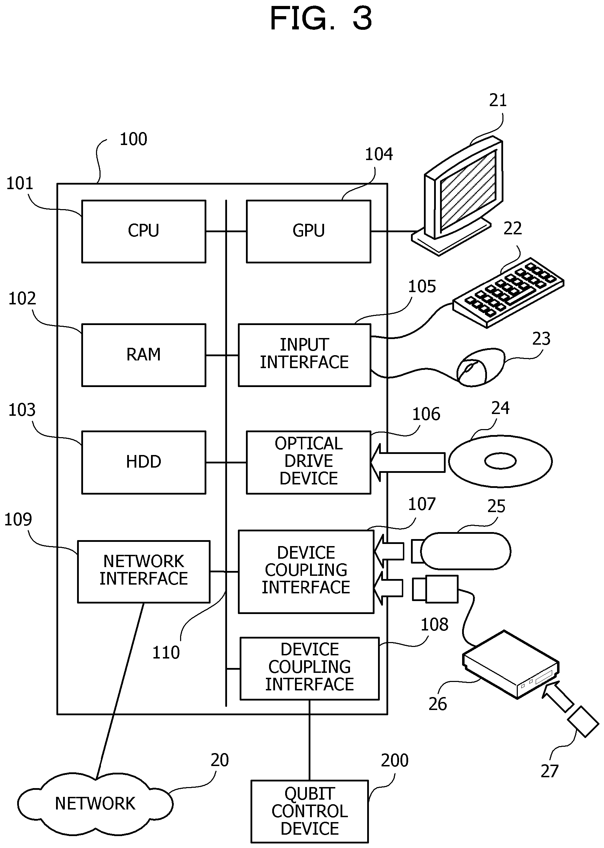

FIG. 3 is a diagram illustrating a configuration example of hardware of the control computer. The entire device of the control computer 100 is controlled by a central processing unit (CPU) 101. The CPU 101 is a processor that executes a program command. Note that the CPU 101 may include a plurality of processor cores. Furthermore, the CPU 101 may be a plurality of processors, or may be a micro processing unit (MPU), a digital signal processor (DSP), or the like. Furthermore, at least a part of functions implemented by the CPU 101 executing a program may be implemented by an electronic circuit such as an application specific integrated circuit (ASIC) or a programmable logic device (PLD). To the CPU 101, a random access memory (RAM) 102 and a plurality of peripheral devices are coupled via a bus 110.

The RAM 102 is a main storage device of the control computer 100. In the RAM 102, at least a part of an operating system (OS) program or an application program to be executed by the CPU 101 is temporarily stored. Furthermore, in the RAM 102, various types of data to be used in processing by the CPU 101 are stored. Note that the control computer 100 may include a memory of a type other than the RAM, or may include a plurality of memories.

Examples of the peripheral devices coupled to the bus 110 include a hard disk drive (HDD) 103, a graphics processing unit (GPU) 104, an input interface 105, an optical drive device 106, device coupling interfaces 107 and 108, and a network interface 109.

The HDD 103 is an auxiliary storage device of the control computer 100. The HDD 103 magnetically writes data to and reads data from a built-in magnetic disk. In the HDD 103, an OS program, an application program, and various types of data are stored. Note that the control computer 100 may include other types of auxiliary storage devices such as a flash memory and a solid state drive (SSD), or may include a plurality of auxiliary storage devices.

A monitor 21 is coupled to the GPU 104. The GPU 104 displays an image on a screen of the monitor 21 according to a command from the CPU 101. Examples of the monitor 21 include a display device using organic electro luminescence (EL), a liquid crystal display device, and the like.

A keyboard 22 and a mouse 23 are coupled to the input interface 105. The input interface 105 transmits signals transmitted from the keyboard 22 and the mouse 23 to the CPU 101. Note that the mouse 23 is an example of a pointing device, and another pointing device may also be used. Examples of the another pointing device include a touch panel, a tablet, a touch pad, a track ball, and the like.

The optical drive device 106 reads data recorded in an optical disk 24 by using a laser beam or the like. The optical disk 24 is a portable recording medium in which data is recorded in a manner readable by reflection of light. Examples of the optical disk 24 include a digital versatile disc (DVD), a DVD-RAM, a compact disc read only memory (CD-ROM), a CD-recordable (R)/rewritable (RW), and the like.

The device coupling interface 107 is a communication interface for coupling the peripheral devices to the control computer 100. For example, a memory device 25 and a memory reader/writer 26 may be coupled to the device coupling interface 107. The memory device 25 is a recording medium equipped with a communication function with the device coupling interface 107. The memory reader/writer 26 is a device that writes data to a memory card 27 or reads data from the memory card 27. The memory card 27 is a card type recording medium.

The device coupling interface 108 is a communication interface for coupling the qubit control device 200 to the control computer 100. The control computer 100 transmits an instruction for controlling qubits to the qubit control device 200 via the device coupling interface 108.

The network interface 109 is coupled to the network 20. The network interface 109 exchanges data with another computer or communication device via the network 20.

The control computer 100 may implement processing functions of the second embodiment with the hardware configuration as described above. Note that the quantum circuit design device 10 indicated in the first embodiment may also be implemented by hardware similar to that of the control computer 100 illustrated in FIG. 3. Furthermore, the CPU 101 is an example of the processing unit 11 indicated in the first embodiment.

The control computer 100 implements the processing functions of the second embodiment by executing, for example, a program recorded in a computer-readable recording medium. A program in which processing content to be executed by the control computer 100 is described may be recorded in various recording media. For example, the program to be executed by the control computer 100 may be stored in the HDD 103. The CPU 101 loads at least a part of the programs in the HDD 103 into the RAM 102, and executes the loaded program. Furthermore, the program to be executed by the control computer 100 may also be recorded in a portable recording medium such as the optical disk 24, the memory device 25, or the memory card 27. For example, the program stored in the portable recording medium may be executed after being installed to the HDD 103 under the control of the CPU 101. Furthermore, the CPU 101 may directly read and execute the program from the portable recording medium.

In the second embodiment, the quantum computer 300 executes quantum calculation. Examples of quantum algorithm executable by the quantum computer 300 include Grover's algorithm.

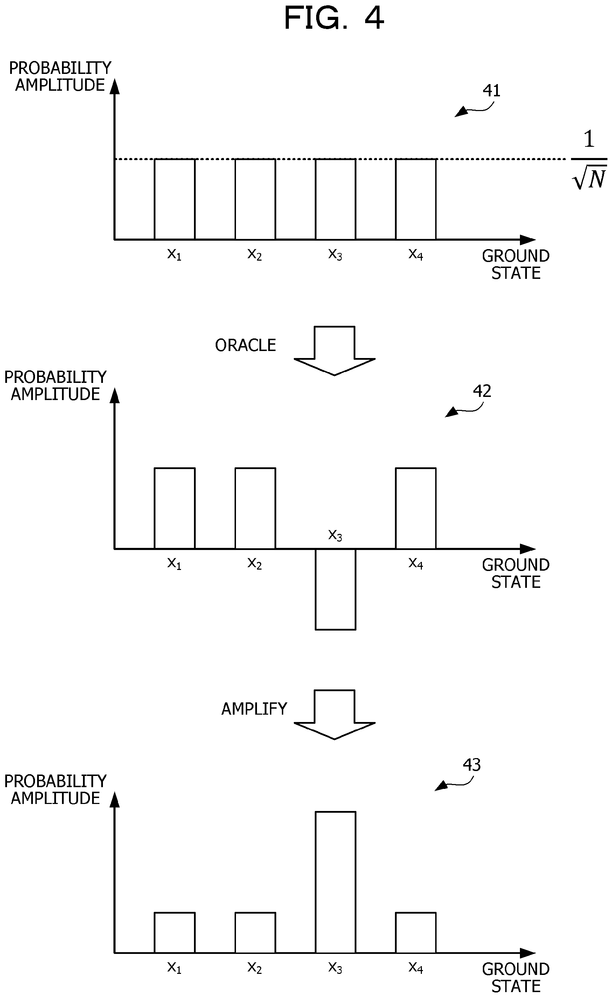

FIG. 4 is a diagram illustrating an example of a change in probability amplitude according to the Grover's algorithm. In the Grover's algorithm, it is possible to search for correct answer data from N pieces of data by repeating the following probability amplitude inversion amplification processing $N^{1/2}$ times.

A graph 41 illustrates a probability amplitude of each of the ground states $x_1$ to $x_4$ in a superposed state of the ground states $x_1$, $x_2$, $x_3$, and $x_4$. Note that the ground states $x_1$ to $x_4$ each correspond to data to be searched for. In the graph 41, the probability amplitude of each of the ground states $x_1$ to $x_4$ is $N^{-1/2}$.

An oracle $U_f$ is applied in inversion processing of the Grover's algorithm. The oracle $U_f$ is indicated by the following Expression (1).

[Expression 1]

$$U_f = -\sum_x (-1)^{f(x)} |x\rangle\langle x| = I - 2|v\rangle\langle v| \qquad (1)$$

In Expression (1), x indicates each ground state. Furthermore, in Expression (1), v is a ground state corresponding to the correct answer data. Furthermore, f(x) in Expression (1) is a function that satisfies f(v) = 1 and f(x) = 0 when x is other than v. Furthermore, in Expression (1), I is an identity matrix of N rows and N columns.

A graph 42 illustrates a probability amplitude of each of the ground states $x_1$ to $x_4$ in a case where the oracle $U_f$ is applied to the superposed state of the ground states $x_1$ to $x_4$ illustrated in the graph 41. Note that the ground state corresponding to the correct answer data is assumed to be the ground state $x_3$. In the graph 42, a sign of the probability amplitude is inverted with respect to the graph 41 only in the ground state $x_3$ among the ground states $x_1$ to $x_4$.

In the amplification processing of the Grover's algorithm, -W indicated by the following Expression (2) is applied.

[Expression 2]

$$-W = 2|w\rangle\langle w| - I \qquad (2)$$

In Expression (2), w indicates a superposed state of all the states. A graph 43 illustrates a probability amplitude of each of the ground states $x_1$ to $x_4$ in a case where -W is applied to the state illustrated in the graph 42. In the graph 43, the probability amplitudes of the ground states $x_1$ to $x_4$ are inverted around an average value with respect to the graph 42. By such inversion amplification processing, the probability amplitude of the ground state $x_3$ corresponding to the correct answer data becomes larger than that of the ground states $x_1$, $x_2$, and $x_4$.

Next, a specific example in which the Grover's algorithm as described above is executed with three qubits will be described. A superposed state $|\psi\rangle$ of states indicated by the three qubits is indicated by the following Expression (3).

[Expression 3]

$$|\psi\rangle = \left(\frac{|0\rangle + |1\rangle}{\sqrt{2}}\right)^{\otimes 3}$$
$$= \frac{1}{\sqrt{8}}(|000\rangle + |001\rangle + |010\rangle + |011\rangle + |100\rangle + |101\rangle + |110\rangle + |111\rangle) \qquad (3)$$

Expression (3) indicates that, for each of the three qubits, a probability amplitude of being in a state "0" and a probability amplitude of being in a state "1" are $2^{-1/2}$. Furthermore, Expression (3) indicates that a probability amplitude of each of states "000" to "111" indicated by the three qubits is $8^{-1/2}$. Here, when a state "010" is assumed to correspond to the correct answer data, a state $U_f|\psi\rangle$ to which the oracle $U_f$ is applied is indicated by the following Expression (4).

[Expression 4]

$$U_f|\psi\rangle = \frac{1}{\sqrt{8}}(|000\rangle + |001\rangle - |010\rangle + |011\rangle + |100\rangle + |101\rangle + |110\rangle + |111\rangle) \qquad (4)$$

Expression (4) indicates that, among the states "000" to "111", a probability amplitude of the state "010" is $-8^{-1/2}$, and probability amplitudes of the states other than the state "010" are $8^{-1/2}$. That is, Expression (4) indicates a state where a sign of the probability amplitude of the state "010" is inverted from the state indicated by Expression (3). Furthermore, an average value of the probability amplitude in the state $U_f|\psi\rangle$ is indicated by the following Expression (5).

[Expression 5]

$$\left(7\frac{1}{\sqrt{8}} - \frac{1}{\sqrt{8}}\right)/8 = \frac{6}{8}\frac{1}{\sqrt{8}} \qquad (5)$$

A state $-WU_f|\psi\rangle$ where -W is applied to the state $U_f|\psi\rangle$ is indicated by the following Expression (6).

[Expression 6]

$$-WU_f|\psi\rangle = \left(\frac{6}{8}\frac{1}{\sqrt{8}} - \frac{1}{\sqrt{8}} + \frac{6}{8}\frac{1}{\sqrt{8}}\right)|000\rangle + \cdots + \left(\frac{6}{8}\frac{1}{\sqrt{8}} + \frac{1}{\sqrt{8}} + \frac{6}{8}\frac{1}{\sqrt{8}}\right)|010\rangle + \cdots$$
$$+ \left(\frac{6}{8}\frac{1}{\sqrt{8}} - \frac{1}{\sqrt{8}} + \frac{6}{8}\frac{1}{\sqrt{8}}\right)|111\rangle \qquad (6)$$

Expression (6) indicates a state where the probability amplitudes of the states "000" to "111" are inverted around the average value of the probability amplitude indicated by Expression (5) from the state represented by Expression (4). A probability of becoming the state "010" in the state - WU$_f$|ψ> is a square of the probability amplitude, and thus is indicated by the following Expression (7).

[Expression 7]

$$\left(\frac{6}{8}\frac{1}{\sqrt{8}} + \frac{1}{\sqrt{8}} + \frac{6}{8}\frac{1}{\sqrt{8}}\right)^2 = 0.781 \qquad (7)$$

As described above, when -WU$_f$ is applied to the superposed state |ψ> of the states "000" to "111", the probability of becoming the state "010" increases to 0.781 from 0.125, which is a probability of randomly becoming one of the eight states. Note that when -WU$_f$ is applied twice to the state |ψ>, the probability of becoming the state "010" is 0.945.

Next, a quantum circuit for causing the quantum computer 300 to execute the Grover's algorithm will be described.

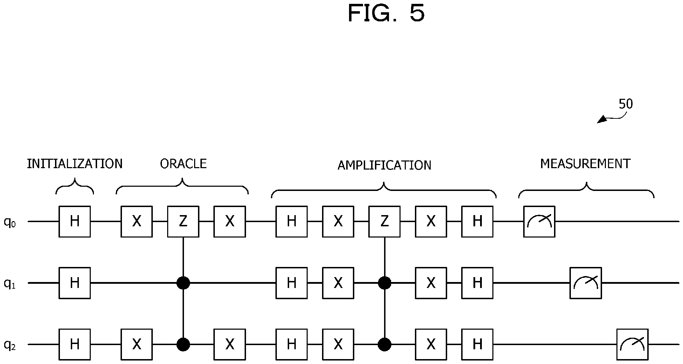

FIG. 5 is a diagram illustrating an example of the quantum circuit that executes the Grover's algorithm with three qubits. A quantum circuit 50 indicates order of operations for the respective qubits $q_0$, $q_1$, and $q_2$ in a case where the Grover's algorithm with the number of times of repetition of one is executed with the three qubits. The quantum circuit 50 has lines corresponding to the respective qubits $q_0$, $q_1$, and $q_2$. In the quantum circuit 50, the line corresponding to the qubit $q_0$, the line corresponding to the qubit $q_1$, and the line corresponding to the qubit $q_2$ are arranged in order from the top. In the quantum circuit 50, an element indicating an operation performed earlier is arranged on the left.

In the quantum circuit 50, each of blocks described as H arranged on the lines corresponding to the respective qubits $q_0$, $q_1$, and $q_2$ indicates an H gate (Hadamard gate). The H gate indicates an operation of creating a superposed state. Furthermore, in the quantum circuit 50, each of blocks described as X arranged on the lines corresponding to the respective qubits $q_0$, $q_1$, and $q_2$ indicates an X gate. The X gate indicates an operation of inverting a bit of a qubit corresponding to an arranged line.

Furthermore, in the quantum circuit 50, each of blocks described as Z arranged on the lines corresponding to the respective qubits $q_0$, $q_1$, and $q_2$ and two points coupled to the block described as Z by a line and arranged on the lines corresponding to the respective qubits $q_0$, $q_1$, and $q_2$ indicate a CCZ gate. Note that the block described as Z is arranged on a line corresponding to a qubit to be a target bit of the CCZ gate, and the two points are arranged on lines corresponding to the respective qubits to be two control bits of the CCZ gate. The CCZ gate indicates that, in a case where the two control bits are "1", a Z gate is acted (phase is inverted) on the one target bit.

Note that the CCZ gate is equivalent no matter which combination of the two control bits and the one target bit is set from the three qubits. That is, the CCZ gate in which the qubits $q_1$ and $q_2$ are the control bits and the qubit $q_0$ is the target bit may be replaced with a CCZ gate in which the qubits $q_0$ and $q_2$ are the control bits and the qubit $q_1$ is the target bit. Furthermore, the CCZ gate in which the qubits $q_1$ and $q_2$ are the control bits and the qubit $q_0$ is the target bit may be replaced with a CCZ gate in which the qubits $q_0$ and $q_1$ are the control bits and the qubit $q_2$ is the target bit. Hereinafter, the CCZ gate in which the two control bits and the one target bit are set from the qubits $q_0$, $q_1$, and $q_2$ may be referred to as the CCZ gate for the qubits $q_0$, $q_1$, and $q_2$.

In the quantum circuit 50, each of blocks arranged on the lines corresponding to the respective qubits $q_0$, $q_1$, and $q_2$, in which a figure obtained by combining a semicircular arc and a straight line is described, indicates measurement. By the measurement, each of the qubits $q_0$, $q_1$, and $q_2$ is determined to be the state of "0" or "1".

The H gate for each of the qubits $q_0$, $q_1$, and $q_2$ is arranged at a left end of the quantum circuit 50. As a first operation indicated by the quantum circuit 50, the H gate is acted on each of the qubits $q_0$, $q_1$, and $q_2$, so that the qubits $q_0$, $q_1$, and $q_2$ are in the superposed state indicated by Expression (3) (initialized). Furthermore, in the quantum circuit 50, a combination of the X gates and the CCZ gate indicating processing of applying the oracle is arranged on the right side of the H gates indicating initialization. Furthermore, in the quantum circuit 50, a combination of the H gates, the X gates, and the CCZ gate indicating the amplification processing is arranged on the right side of the combination of the gates indicating the oracle. Furthermore, in the quantum circuit 50, observation for each of the qubits $q_0$, $q_1$, and $q_2$ is arranged on the right side of the combination of the gates indicating the amplification processing. By the observation indicated in the quantum circuit 50, a result of performing the inversion amplification processing of the Grover's algorithm once is output.

Note that the quantum computer 300 may include a device that performs a gate operation on equal to or smaller than two qubits, and may not have the device that may perform a gate operation on equal to or more than three qubits. Thus, a gate for three qubits such as the CCZ gate is converted into an equivalent circuit obtained by combining gates for two qubits or one qubit.

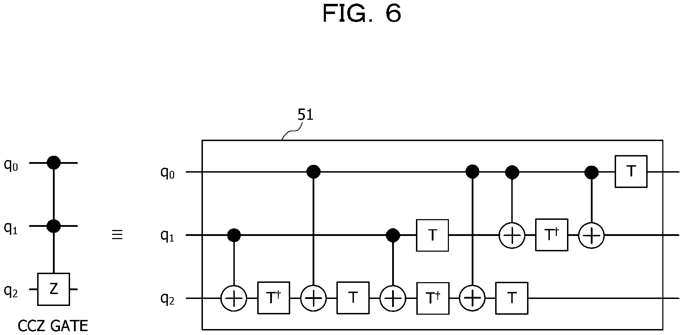

FIG. 6 is a diagram illustrating an example of an equivalent circuit of the CCZ gate for a superconducting quantum computer. An equivalent circuit 51 is a quantum circuit that is equivalent to the CCZ gate for the qubits $q_0$, $q_1$, and $q_2$ and obtained by combining gates for two qubits or one qubit. In the equivalent circuit 51, each of blocks described as T arranged on the lines corresponding to the respective qubits $q_0$, $q_1$, and $q_2$ indicates a T gate. The T gate indicates an operation of rotating a phase by a predetermined value. Furthermore, in the equivalent circuit 51, each of blocks described as $T^\dagger$ arranged on the lines corresponding to the respective qubits $q_0$, $q_1$, and $q_2$ indicates a $T^\dagger$ gate. The $T^\dagger$ gate indicates an operation of rotating the phase by the predetermined value in an opposite direction to a direction of the rotation by the T gate.

Furthermore, in the equivalent circuit 51, each of symbols obtained by combining + and a circle arranged on the lines corresponding to the respective qubits $q_0$, $q_1$, and $q_2$, and a point coupled to the symbol by a line and arranged on the line corresponding to one of the respective qubits $q_0$, $q_1$, and $q_2$ indicate a CNOT gate. Note that the symbol obtained by combining + and the circle is arranged on a line corresponding to a qubit to be a target bit of the CNOT gate, and the point is arranged on a line corresponding to a qubit to be a control bit of the CNOT gate. The CNOT gate indicates that a bit of the target bit is inverted in a case where the control bit is "1".

As described above, the CCZ gate may be converted into the equivalent circuit 51 obtained by combining the gates for two qubits or one qubit. Note that the equivalent circuit 51 illustrated in FIG. 6 is for the superconducting quantum computer. In the case of the ion trap quantum computer, the two qubits are replaced with an equivalent circuit using an XX gate. The XX gate is a gate that simultaneously rotates two qubits by a predetermined angle about an X axis. The XX gate is one of gates called an Ising gate.

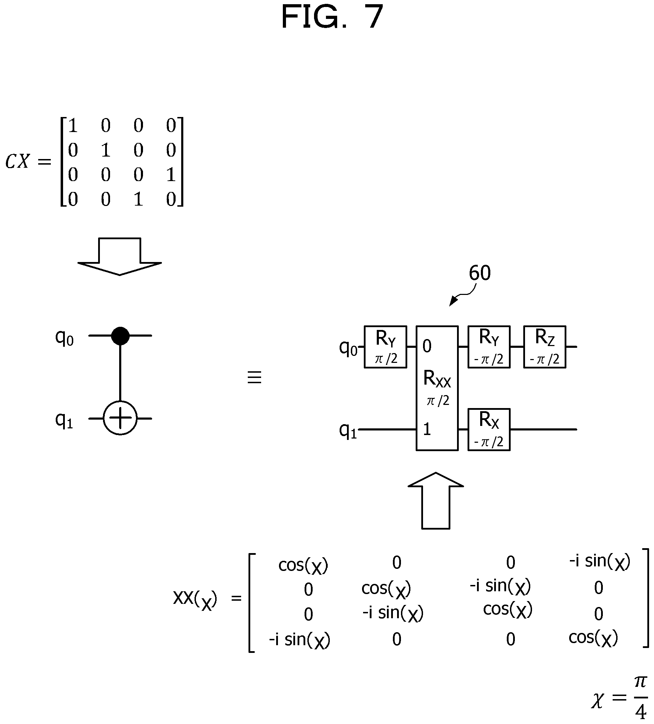

FIG. 7 is a diagram illustrating an example of an equivalent circuit of a CX gate using the XX gate. The CX gate is represented by the following Expression (8).
[Expression 8]

$$CX = \begin{bmatrix} 1 & 0 & 0 & 0 \\ 0 & 1 & 0 & 0 \\ 0 & 0 & 0 & 1 \\ 0 & 0 & 1 & 0 \end{bmatrix} \qquad (8)$$

On the other hand, the XX gate is represented by the following Expression (9).
[Expression 9]

$$XX(\chi) = \begin{bmatrix} \cos(\chi) & 0 & 0 & -i\sin(\chi) \\ 0 & \cos(\chi) & -i\sin(\chi) & 0 \\ 0 & -i\sin(\chi) & \cos(\chi) & 0 \\ -i\sin(\chi) & 0 & 0 & \cos(\chi) \end{bmatrix} \qquad (9)$$

By using the XX gate, an equivalent circuit 60 of the CX gate may be created. A value of $\chi$ of the XX gate in that case is "n/4". In the equivalent circuit 60, a block described as $R_X$ indicates a rotation operation of a Bloch sphere around the X axis. Each of blocks described as $R_Y$ indicates a rotation operation of the Bloch sphere around a Y axis. A block described as indicates a rotation operation of the Bloch sphere around a Z axis. An angle ($\pm\pi/2$) described in each block is a rotation angle around each axis.

In the equivalent circuit 60, a block across two qubits is the XX gate. In the XX gate, the qubit described as "0" corresponds to a control bit in the CX gate, and the qubit described as "1" corresponds to a target bit in the CX gate. An angle described in the block indicating the XX gate is a rotation angle of the two qubits to be operated. In the case of the equivalent circuit 60 of the CX gate, the rotation angle by the XX gate is $\pi/2$. A value obtained by dividing the rotation angle by 2 is the value of $\chi$ in Expression (9) of the XX gate.

By using such an XX gate, an equivalent circuit applicable to the ion trap quantum computer may also be generated for the CCZ gate.

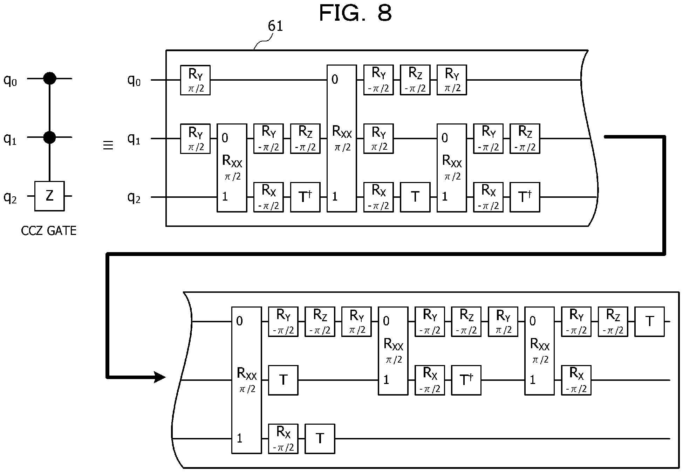

FIG. 8 is a diagram illustrating a first example of the equivalent circuit of the CCZ gate using the XX gate. An equivalent circuit 61 of the CCZ gate is created by combining the XX gates indicating a rotation operation of $\pi/2$ to two qubits, the gates ($R_x$, $R_y$, $R_z$) indicating a rotation operation of $\pm\pi/2$ around each axis of the Bloch sphere, the T gates, and the $T^\dagger$ gates. Note that there is a plurality of the equivalent circuits using the XX gate of the CCZ gate other than the equivalent circuit 61 illustrated in FIG. 8. Here, it is assumed that an identification number of the equivalent circuit 61 among the plurality of equivalent circuits using the XX gate of the CCZ gate is "#0".

In a case where the ion trap quantum computer 300 executes the processing indicated by the quantum circuit 50, it is conceivable that the control computer 100 generates a quantum circuit obtained by converting each of the two CCZ gates included in the quantum circuit 50 into the equivalent circuit 61. Then, it is conceivable that the control computer 100 instructs the qubit control device 200 to control qubits according to the generated quantum circuit.

Here, in quantum calculation by the quantum computer 300, an error may occur in each qubit due to noise included in a gate operation. Examples of the errors in the qubits include an error due to interference with an external environment (stochastic Pauli, depolarization, amplitude damping, or phase damping) and an error that occurs only inside (coherent error). The coherent error is an error due to defective implementation of a quantum gate, and it is difficult to completely remove the coherent error. The coherent error includes a one-qubit error and a two-qubit error. In an actual device, a probability of occurrence of the two-qubit error is larger than that of the one-qubit error by about 10. Therefore, an influence of the two-qubit error on the entire error is larger than that of the one-qubit error.

Therefore, in a case where the two CCZ gates included in the quantum circuit 50 are converted into the equivalent circuits 61, an error is likely to occur in a qubit having a large number of gate operations in the equivalent circuits 61. For example, in the equivalent circuit 61 illustrated in FIG. 8, the qubit $q_0$ has a larger number of operations than those of the other qubits, and an error is likely to occur in the qubit $q_0$. Then, in a case where the quantum circuit 50 illustrated in FIG. 5 is calculated by the ion trap quantum computer 300, when the two CCZ gates are both implemented by the equivalent circuit 61, a bias occurs in a probability of occurrence of an error for each qubit. The bias of the probability of occurrence of an error for each qubit affects a probability of obtaining a correct calculation result in calculation of the Grover's algorithm.

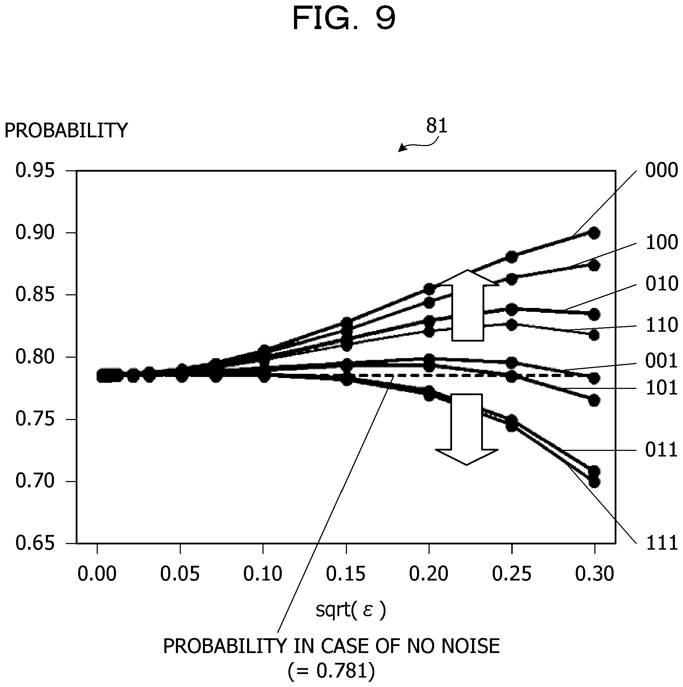

FIG. 9 is a diagram illustrating an example of a relationship between a quantum calculation result and noise in a case where the CCZ gates are replaced with the same equivalent circuit. A graph 81 illustrates a simulation result of quantum calculation by a quantum circuit obtained by converting the two CCZ gates included in the Grover's algorithm with the three qubits into the equivalent circuits 61 while changing a noise amount of a gate operation. A vertical axis of the graph 81 indicates a probability that a state corresponding to correct answer data is output. A horizontal axis of the graph 81 indicates the noise amount included in the gate operation. Note that sqrt($\varepsilon$) is an index of the noise amount included in the gate operation. Each line of the graph 81 indicates a simulation result in a case where the state corresponding to the correct answer data is each of "000" to "111".

In all of each line of the graph 81, a probability in the case of no noise is "0.781". In each line, as the noise increases, a difference from the probability "0.781" in the case of no noise increases. A degree of the difference from the probability in the case of no noise depends on the oracle. In other words, the probability in a case where there is noise changes depending on which state is searched for. Additionally, no matter which state is searched for, generally, as coherent noise increases, the difference between the output probability and the probability in the case of no noise increases. The larger the difference between the output probability and the probability in the case of no noise, the larger the influence of the noise is.

Thus, in the second embodiment, in a case where a quantum circuit includes a plurality of the CCZ gates, the control computer 100 converts a part of the CCZ gates into the equivalent circuit 61, and converts the remaining CCZ gate into an equivalent circuit arranged by symmetrically moving each element of the equivalent circuit 61 up and down.

Next, functions of the control computer 100 will be described in detail.

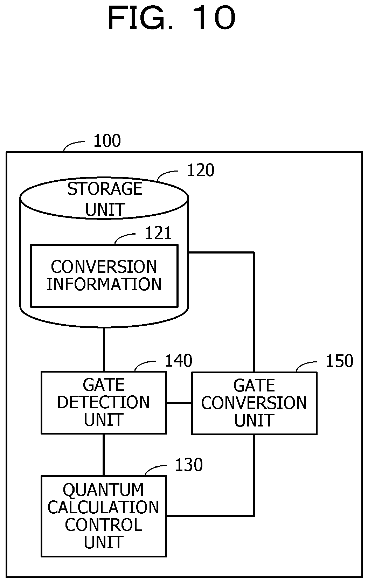

FIG. 10 is a block diagram illustrating a functional example of the control computer. The control computer 100 includes a storage unit 120, a quantum calculation control unit 130, a gate detection unit 140, and a gate conversion unit 150. The storage unit 120 stores conversion information 121. In the conversion information 121, a gate to be converted and an equivalent circuit are registered in association with each other.

The quantum calculation control unit 130 controls quantum calculation. First, the quantum calculation control unit 130 acquires a quantum circuit. For example, the quantum calculation control unit 130 receives, from the terminal devices 31, 32, ..., requests for quantum calculation by the quantum computer 300 and quantum circuits. Then, the quantum calculation control unit 130 controls the qubit control device 200 according to quantum circuits obtained by conversion by the gate conversion unit 150.

The gate detection unit 140 detects a CCZ gate from a quantum circuit acquired by the quantum calculation control unit 130. Furthermore, in a case where the CCZ gate is detected from the quantum circuit, the gate detection unit 140 detects a CCZ gate for the same combination of qubits as the detected CCZ gate.

The gate conversion unit 150 converts gates for equal to or more than three qubits included in a quantum circuit into an equivalent circuit obtained by combining a one-bit gate or a two-bit gate. For example, the gate conversion unit 150 performs conversion into an equivalent circuit obtained by combining a one-bit gate indicating a rotation operation around an axis and the XX gate. For example, the gate conversion unit 150 converts a CCZ gate detected by the gate detection unit 140 into the equivalent circuit 61. Furthermore, the gate conversion unit 150 converts a CCZ gate for the same combination of qubits as the CCZ gate converted into the equivalent circuit into an equivalent circuit obtained by symmetrically moving elements of the converted equivalent circuit. For example, the gate conversion unit 150 converts the CCZ gate into an equivalent circuit arranged by symmetrically moving each element of the equivalent circuit 61 up and down.

Note that, lines coupling the respective elements illustrated in FIG. 10 indicate a part of communication paths, and a communication path other than the illustrated communication paths may also be set. Furthermore, the function of each element illustrated in FIG. 10 may be implemented by, for example, causing a computer to execute a program module corresponding to the element.

Next, the conversion information 121 stored in the storage unit 120 will be described in detail.

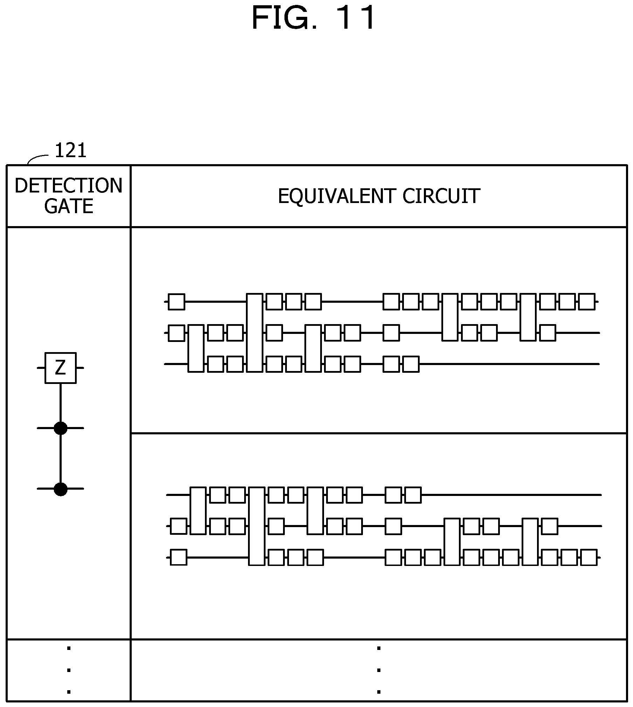

FIG. 11 is a diagram illustrating an example of the conversion information. The conversion information 121 is provided with fields of a detection gate and an equivalent circuit. A gate to be detected is set in the field of the detection gate. An equivalent circuit of the gate to be detected is set in the field of the equivalent circuit. For example, in the conversion information 121, a CCZ gate, and the equivalent circuit 61 and an equivalent circuit arranged by symmetrically moving each element of the equivalent circuit 61 up and down are registered in association with each other.

The gate conversion unit 150 may determine an equivalent circuit corresponding to gate operations of equal to or more than three qubits based on the conversion information 121.

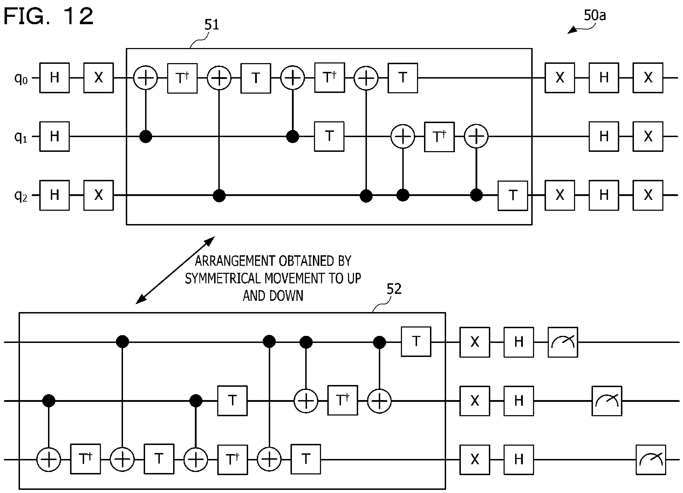

FIG. 12 is a diagram illustrating an example of a quantum circuit after conversion in a case where quantum calculation is performed by the superconducting quantum computer. The gate conversion unit 150 converts the quantum circuit 50 into a quantum circuit 50a by quantum circuit conversion processing. The quantum circuit 50a is obtained by converting one of the two CCZ gates included in the quantum circuit 50 into the equivalent circuit 51 and converting the other into an equivalent circuit 52. The equivalent circuit 52 is an equivalent circuit arranged by symmetrically moving each element of the equivalent circuit 51 up and down. In the equivalent circuit 52, the arrangement of each element of the equivalent circuit 51 is inverted around the line corresponding to the qubit $q_1$ as an axis.

Similarly to the example of FIG. 12, even in a case where an equivalent circuit for the ion trap quantum computer is generated, a plurality of CCZ gates may be converted into different equivalent circuits.

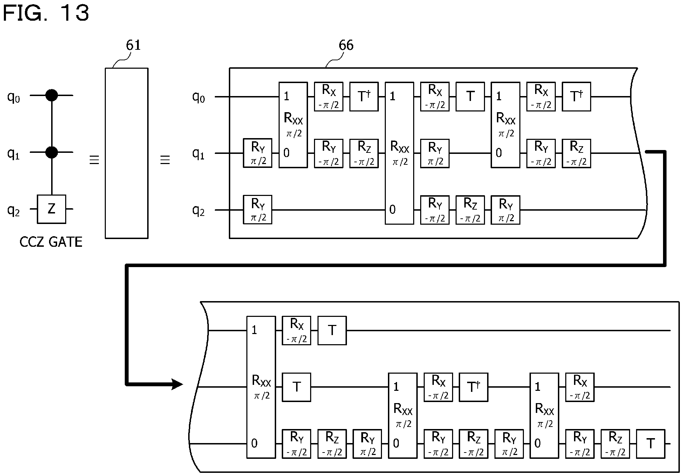

FIG. 13 is a diagram illustrating a second example of the equivalent circuit of the CCZ gate using the XX gate. An equivalent circuit 66 has a configuration obtained by symmetrically moving arrangement of each element in the equivalent circuit 61 of "#0" illustrated in FIG. 8 around the line corresponding to the qubit $q_1$ as an axis. The equivalent circuit 66 is also equivalent to the CCZ gate similarly to the equivalent circuit 61. It is assumed that an identification number of the equivalent circuit is "#5" (equivalent circuits with identification numbers "#1 to #4" will be described later).

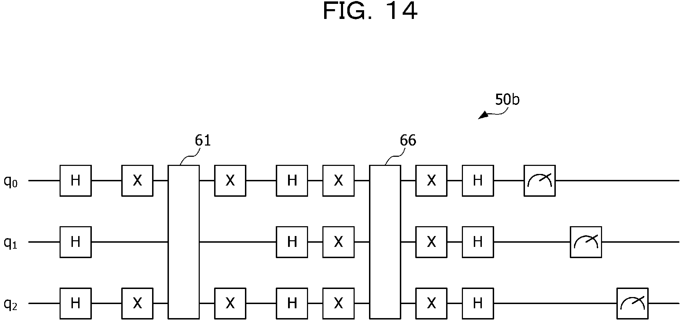

FIG. 14 is a diagram illustrating an example of a quantum circuit after conversion in a case where quantum calculation is performed by the ion trap quantum computer. In a case where quantum calculation of the quantum circuit 50 is performed by the ion trap quantum computer, the gate conversion unit 150 converts, for example, the quantum circuit 50 into a quantum circuit 50b. The quantum circuit 50b is obtained by converting one of the two CCZ gates included in the quantum circuit 50 into the equivalent circuit 61 (see FIG. 8) and converting the other into the equivalent circuit 66 (see FIG. 13).

When the quantum circuit 50 is acquired, the quantum calculation control unit 130 controls the qubit control device 200 according to the quantum circuit 50b converted by the gate conversion unit 150. The qubit control device 200 performs gate operations on each qubit in order indicated in the quantum circuit 50b. As a result, a bias of the gate operation on a specific qubit is suppressed as compared with the case where the two CCZ gates included in the quantum circuit 50 are converted into the equivalent circuits 61.

Next, conversion processing of a CCX gate by the gate conversion unit 150 will be described. Note that the CCX gate is also called a Toffoli gate.

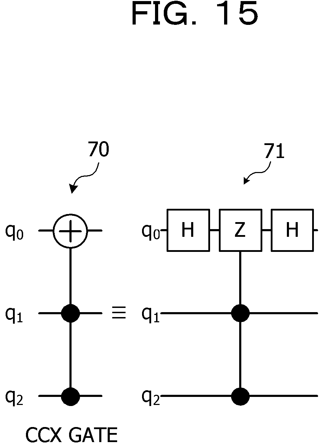

FIG. 15 is a diagram illustrating an example of the conversion processing of the CCX gate. A CCX gate 70 indicates that, in a case where two control bits are "1", the X gate is acted on one target bit (phase is inverted). In a quantum circuit, a symbol obtained by combining + and a circle is arranged on a line corresponding to a qubit to be the target bit of the CCX gate 70, and points coupled to the symbol by a line are arranged on lines corresponding to the respective qubits to be the two control bits. The CCX gate 70 may convert the CCX gate included in the quantum circuit into an equivalent circuit 71 obtained by combining the H gates and the CCZ gate.

In the equivalent circuit 71, the H gate for the qubit $q_0$, the CCZ gate for the qubits $q_0$, $q_1$, and $q_2$, and the H gate for the qubit $q_0$ are arranged side by side. The gate conversion unit 150 may perform conversion into an equivalent circuit for the ion trap quantum computer equivalent to the CCX gate 70 by, for example, converting the CCZ gate included in the equivalent circuit 71 into the equivalent circuit 61.

As described above, the gate conversion unit 150 may convert the CCX gate included in a quantum circuit into an equivalent circuit including the CCZ gate. Additionally, by converting the CCZ gate into an equivalent circuit, the gate conversion unit 150 may suppress a gate operation from being biased to a specific qubit in the quantum circuit including the CCX gate. Additionally, by using the equivalent circuit 71 of the CCX gate 70, it is possible to suppress a bias of the number of operations between qubits even in operations of a large number of bits of equal to or more than four bits.

Next, conversion processing of a CnNOT gate by the gate conversion unit 150 will be described.

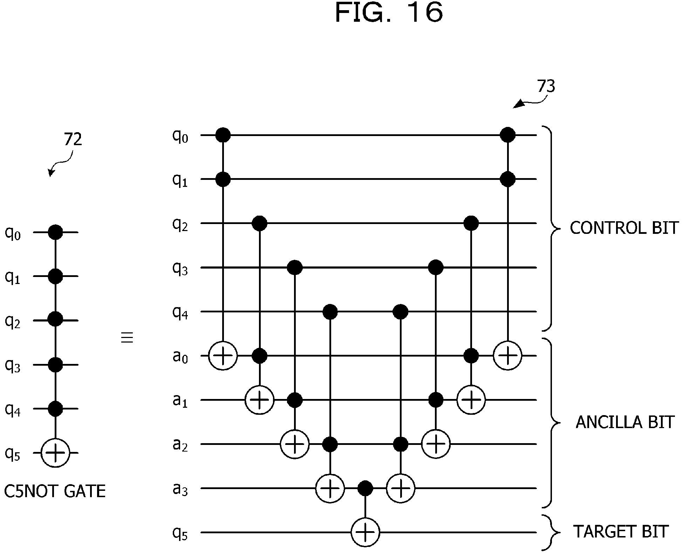

FIG. 16 is a diagram illustrating an example of the conversion processing of the CnNOT gate. The CnNOT gate indicates that a bit of one target bit is inverted in a case where all n (n is an integer equal to or larger than 1) control bits are "1". In a quantum circuit, a symbol obtained by combining + and a circle is arranged on a line corresponding to a qubit to be the target bit of the CnNOT gate, and points coupled to the symbol by a line are arranged on lines corresponding to the respective qubits to be the n control bits. The gate conversion unit 150 converts the CnNOT gate included in the quantum circuit into an equivalent circuit obtained by combining the CCX gates and the CNOT gate.

An equivalent circuit 73 illustrated in FIG. 16 is a quantum circuit equivalent to a C5NOT gate 72 in which the qubits $q_0$, $q_1$, $q_2$, $q_3$, and $q_4$ are the control bits and the qubit $q_5$ is the target bit. The equivalent circuit 73 includes CCX gates in each of which any two of the qubits $q_0$ to $q_4$, $a_0$, $a_1$, $a_2$, and $a_3$ are control bits and any one of the qubits $q_0$ to $q_4$ and $a_0$ to $a_3$

is a target bit. Note that the qubits $a_0$ to $a_3$ are ancilla bits. In the conversion of the CnNOT gate, n-1 ancilla bits are used.

The equivalent circuit 73 includes two CCX gates in which the qubits $q_0$ and $q_1$ are the control bits and the qubit $a_0$ is the target bit. Furthermore, the equivalent circuit 73 includes two CCX gates in which the qubits $q_2$ and $a_0$ are the control bits and the qubit $a_1$ is the target bit. Furthermore, the equivalent circuit 73 includes two CCX gates in which the qubits $q_3$ and $a_1$ are the control bits and the qubit $a_2$ is the target bit. Furthermore, the equivalent circuit 73 includes two CCX gates in which the qubits $q_4$ and $a_2$ are the control bits and the qubit $a_3$ is the target bit. Furthermore, the equivalent circuit 73 includes one CNOT gate in which the qubit $a_3$ is the control bit and the qubit $q_5$ is the target bit.

The gate conversion unit 150 may convert the CCX gate included in the equivalent circuit 73 into an equivalent circuit obtained by combining the CCZ gate and the H gates (see FIG. 15). Therefore, the CnNOT gate may be converted into an equivalent circuit by combining a one-qubit gate and a two-qubit gate.

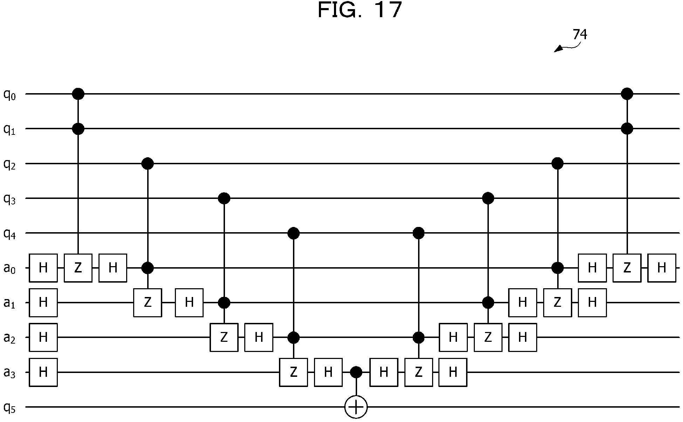

FIG. 17 is a diagram illustrating an example of the equivalent circuit of the CnNOT gate. An equivalent circuit 74 is obtained by converting the CCX gates included in the equivalent circuit 73 into equivalent circuits each of which is obtained by combining the CCZ gate and the H gates. That is, the equivalent circuit 74 includes two CCZ gates for each of the same combinations of qubits. For example, the equivalent circuit 74 includes two CCZ gates for the qubits $q_0$, $q_1$, and $a_0$.

The gate conversion unit 150 converts one of the two CCZ gates for the same combination of qubits included in the equivalent circuit 74 into the equivalent circuit 61, and converts the other into the equivalent circuit 66 arranged by symmetrically moving each element of the equivalent circuit 61 up and down. As a result, the gate conversion unit 150 may suppress a gate operation from being biased to a specific qubit in a quantum circuit including the CnNOT gate.

Next, a procedure of the quantum circuit conversion processing will be described in detail.

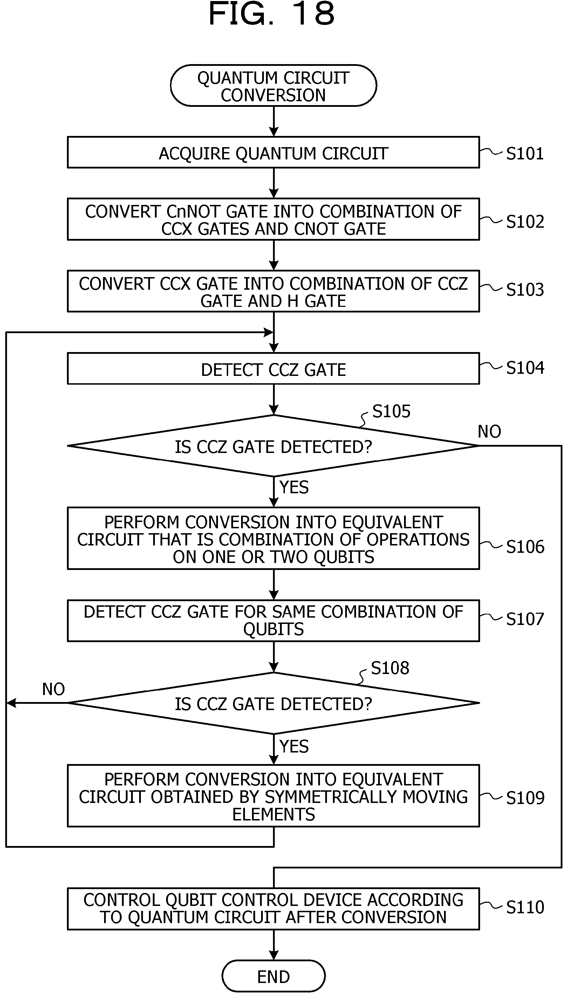

FIG. 18 is a flowchart illustrating an example of the procedure of the quantum circuit conversion processing. Hereinafter, the processing illustrated in FIG. 18 will be described in accordance with step numbers.

[step S101] The quantum calculation control unit 130 acquires a quantum circuit. For example, the quantum calculation control unit 130 receives, from the terminal devices 31, 32, ..., requests for quantum calculation by the quantum computer 300 and quantum circuits.

[step S102] The gate conversion unit 150 converts the CnNOT gate included in the quantum circuit into a combination of the CCX gates and the CNOT gate. For example, the gate conversion unit 150 detects the CnNOT gate included in the quantum circuit acquired in step S101. The gate conversion unit 150 generates an equivalent circuit obtained by combining the CNOT gate with the plurality of CCX gates each having two of control bits of the detected CnNOT gate and n-1 ancilla bits as control bits and one as a target bit. Then, the gate conversion unit 150 converts the detected CnNOT gate into the generated equivalent circuit.

[step S103] The gate conversion unit 150 converts the CCX gate included in the quantum circuit into a combination of the CCZ gate and the H gates. For example, the gate conversion unit 150 detects the CCX gate included in the quantum circuit converted in step S102. The gate conversion unit 150 generates an equivalent circuit in which the H gate for the target bit of the detected CCX gate, the CCZ gate for the control bits and the target bit, and the H gate for the target bit are arranged side by side. Then, the gate conversion unit 150 converts the detected CCX gate into the generated equivalent circuit.

[step S104] The gate detection unit 140 detects one CCZ gate from the quantum circuit.

[step S105] The gate detection unit 140 determines whether or not the CCZ gate is detected from the quantum circuit in step S104. In a case where the gate detection unit 140 determines that the CCZ gate is detected from the quantum circuit in step S104, the processing proceeds to step S106. Furthermore, in a case where the gate detection unit 140 determines that the CCZ gate is not detected from the quantum circuit in step S104, the processing proceeds to step S110.

[step S106] The gate conversion unit 150 converts the CCZ gate detected in step S104 into an equivalent circuit that is a combination of operations on one or two qubits. For example, the gate conversion unit 150 converts the CCZ gate detected in step S104 into the equivalent circuit 61 registered in the conversion information 121.

[step S107] The gate detection unit 140 detects, from the quantum circuit, one CCZ gate for the same combination of qubits as the CCZ gate detected in step S104.

[step S108] The gate detection unit 140 determines whether or not the CCZ gate is detected from the quantum circuit in step S107. In a case where the gate detection unit 140 determines that the CCZ gate is detected from the quantum circuit in step S107, the processing proceeds to step S109. Furthermore, in a case where the gate detection unit 140 determines that the CCZ gate is not detected from the quantum circuit in step S107, the processing proceeds to step S104.

[step S109] The gate conversion unit 150 converts the CCZ gate detected in step S107 into an equivalent circuit obtained by symmetrically moving elements of the equivalent circuit converted in step S106. For example, the gate conversion unit 150 converts the CCZ gate detected in step S107 into the equivalent circuit 66 arranged by symmetrically moving each element of the equivalent circuit 61 registered in the conversion information 121 up and down. Then, the processing proceeds to step S104.

[step S110] The quantum calculation control unit 130 controls the qubit control device 200 according to the quantum circuit after the conversion.

In this manner, the gate conversion unit 150 converts one of the CCZ gates for the same combination of qubits into an equivalent circuit, and converts the other into an equivalent circuit arranged by symmetrically moving each element of the equivalent circuit 51 up and down. As a result, the gate conversion unit 150 may suppress a gate operation from being biased to a specific qubit.

Note that the gate conversion unit 150 converts the CnNOT gate into the combination of the CCX gates and the CNOT gate, converts the CCX gate into the combination of the CCZ gate and the H gates, and then converts the CCZ gate. As a result, the gate conversion unit 150 may suppress a gate operation from being biased to a specific qubit even in a case where the CCX gate or the CnNOT gate is included in a quantum circuit.

Next, an influence of noise included in a gate operation on quantum calculation will be described.

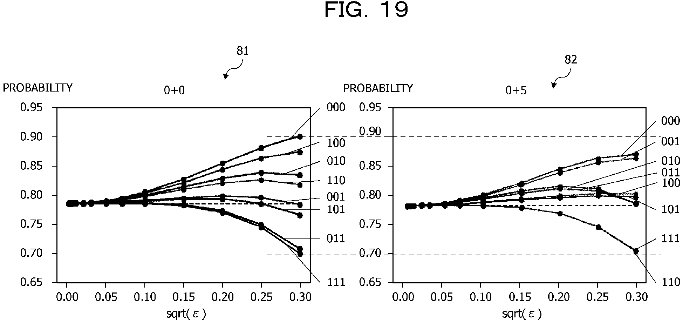

FIG. 19 is a diagram (part 1) illustrating an example of a relationship between a quantum calculation result and noise. The graph 81 illustrates a simulation result of quantum calculation by the quantum circuit obtained by converting the two CCZ gates included in the Grover's algorithm with the three qubits into the equivalent circuit 61 while changing a noise amount of a gate operation. The vertical axis of the graph 81 indicates the output probability of the state corresponding to the correct answer data. The horizontal axis of the graph 81 indicates the noise amount included in the gate operation. Note that $\text{sqrt}(\epsilon)$ is the index of the noise amount included in the gate operation. Each line of the graph 81 indicates the simulation result in the case where the state corresponding to the correct answer data is each of "000" to "111".

A graph 82 illustrates a simulation result of quantum calculation by a quantum circuit obtained by converting one of the two CCZ gates included in the Grover's algorithm with the three qubits into the equivalent circuit 61 and converting the other into the equivalent circuit 66 while changing the noise amount of the gate operation. Meanings of a vertical axis, a horizontal axis, and each line of the graph 82 are similar to those of the graph 81.

The graphs 81 and 82 indicate that, when there is no noise of the gate operation, the output probability of the state corresponding to the correct answer data is the theoretical value 0.781 indicated in Expression (7). Furthermore, the graphs 81 and 82 indicate that the output probability of the state corresponding to the correct answer data decreases as the noise amount of the gate operation increases. Here, in the graph 82, a difference between the output probability with respect to the increase in the noise amount and the theoretical value 0.781 is smaller than that in the graph 81. That is, the graphs 81 and 82 indicate that, when quantum calculation is performed by the quantum circuit obtained by converting one of the two CCZ gates into the equivalent circuit 61 and converting the other into the equivalent circuit 66, an influence of noise may be reduced as compared with the case where quantum calculation is performed by the quantum circuit obtained by converting the two CCZ gates into the equivalent circuits 61.

As described above, the gate conversion unit 150 converts one of the CCZ gates for the same combination of qubits into the equivalent circuit 61 and converts the other into the equivalent circuit 66, so that it is possible to reduce an error generated by an influence of noise included in a gate operation being biased to a specific qubit. Therefore, the gate conversion unit 150 may reduce an error in quantum calculation.

Note that the CCZ gate may also be converted into an equivalent circuit other than the equivalent circuits 61 and 66 indicated in the example described above. The gate conversion unit 150 may convert the CCZ gate into an equivalent circuit other than the equivalent circuits 61 and 66.

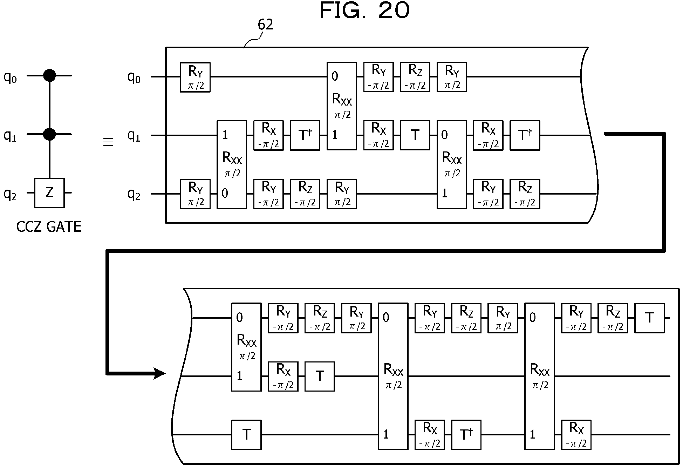

FIG. 20 is a diagram illustrating a third example of the equivalent circuit of the CCZ gate using the XX gate. In an equivalent circuit 62 illustrated in FIG. 20, each element arranged on the line corresponding to the qubit $q_0$ of the equivalent circuit 61 is arranged on a line corresponding to the qubit $q_0$. Furthermore, in the equivalent circuit 62, each element arranged on the line corresponding to the qubit $q_1$ of the equivalent circuit 61 is arranged on a line corresponding to the qubit $q_2$. Furthermore, in the equivalent circuit 62, each element arranged on the line corresponding to the qubit $q_2$ of the equivalent circuit 61 is arranged on a line corresponding to the qubit $q_1$. It is assumed that an identification number of the equivalent circuit 62 is "#1".

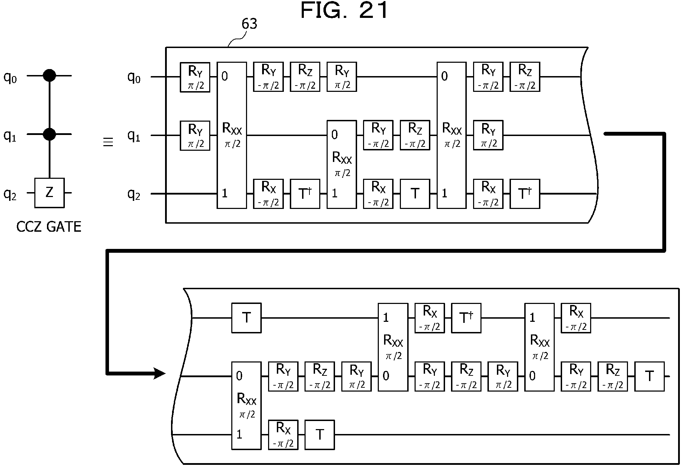

FIG. 21 is a diagram illustrating a fourth example of the equivalent circuit of the CCZ gate using the XX gate. In an equivalent circuit 63 illustrated in FIG. 21, each element arranged on the line corresponding to the qubit $q_0$ of the equivalent circuit 61 is arranged on a line corresponding to the qubit $q_1$. Furthermore, in the equivalent circuit 63, each element arranged on the line corresponding to the qubit $q_1$ of the equivalent circuit 61 is arranged on a line corresponding to the qubit $q_0$. Furthermore, in the equivalent circuit 63, each element arranged on the line corresponding to the qubit $q_2$ of the equivalent circuit 61 is arranged on a line corresponding to the qubit $q_2$. It is assumed that an identification number of the equivalent circuit 63 is "#2".

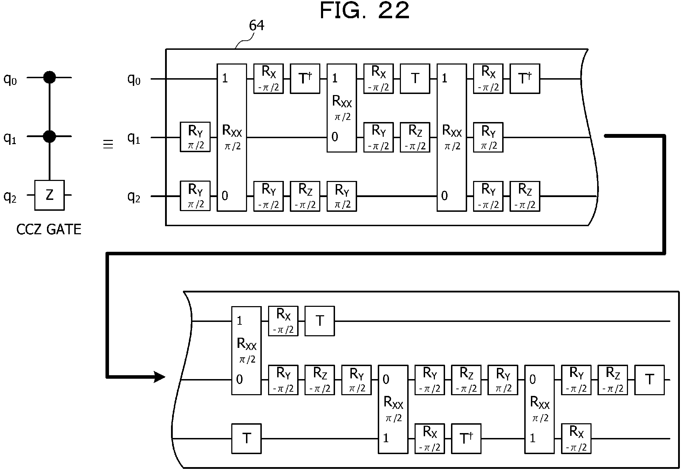

FIG. 22 is a diagram illustrating a fifth example of the equivalent circuit of the CCZ gate using the XX gate. An equivalent circuit 64 illustrated in FIG. 22 has a configuration obtained by symmetrically moving arrangement of each element in the equivalent circuit 63 of "#2" illustrated in FIG. 21 around the line corresponding to the qubit $q_1$ as an axis. It is assumed that an identification number of the equivalent circuit 64 is "#3".

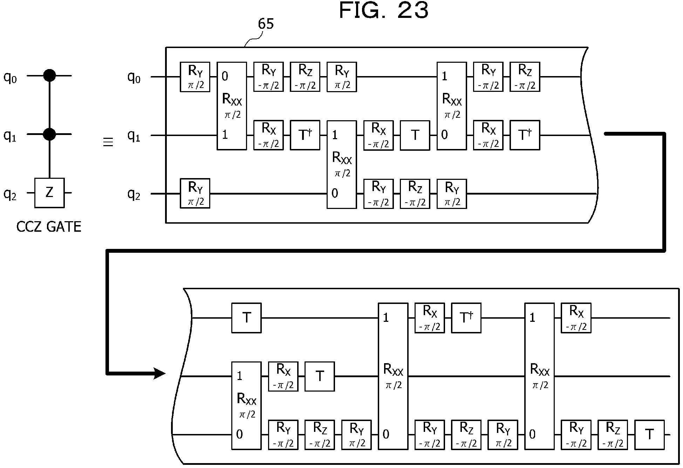

FIG. 23 is a diagram illustrating a sixth example of the equivalent circuit of the CCZ gate using the XX gate. An equivalent circuit 65 illustrated in FIG. 23 has a configuration obtained by symmetrically moving arrangement of each element in the equivalent circuit 62 of "#1" illustrated in FIG. 20 around the line corresponding to the qubit $q_1$ as an axis. It is assumed that an identification number of the equivalent circuit 65 is "#4".

When a set of equivalent circuits in which one has a configuration obtained by symmetrically moving arrangement of elements of the other is generated among the six equivalent circuits 61 to 66 of the CCZ gate, three sets may be generated. In other words, a set of the equivalent circuit 61 of "#0" and the equivalent circuit 66 of "#5", a set of the equivalent circuit 62 of "#1" and the equivalent circuit 65 of "#4", and a set of the equivalent circuit 63 of "#2" and the equivalent circuit 65 of "#4" may be generated. In a case where there are two CCZ gates for the same combination of qubits, the gate conversion unit 150 may convert one CCZ gate into one equivalent circuit constituting any set, and convert the other CCZ gate into the other equivalent circuit constituting the set.

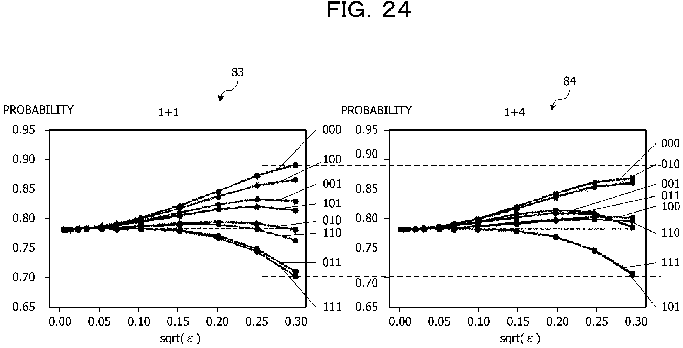

FIG. 24 is a diagram (part 2) illustrating an example of the relationship between the quantum calculation result and the noise. A graph 83 illustrates a simulation result of quantum calculation by a quantum circuit obtained by converting the two CCZ gates included in the Grover's algorithm with the three qubits into the equivalent circuits 62 while changing the noise amount of the gate operation. Furthermore, a graph 84 illustrates a simulation result of quantum calculation by a quantum circuit obtained by converting one of the two CCZ gates included in the Grover's algorithm with the three qubits into the equivalent circuit 62 and converting the other into the equivalent circuit 65 while changing the noise amount of the gate operation. Meanings of a vertical axis, a horizontal axis, and each line of each of the graphs 83 and 84 are similar to those of the graph 81. Note that, in the graph 84, a line indicating a result in a case where a correct answer is "111" and a line indicating a result in a case where the correct answer is "101" substantially overlap.

In the graph 84, a difference between the output probability with respect to the increase in the noise amount and the case where there is no noise is smaller than that in the graph 83. Therefore, the graphs 83 and 84 indicate that, when quantum calculation is performed by the quantum circuit obtained by converting one of the two CCZ gates into the equivalent circuit 62 and converting the other into the equivalent circuit 65, an influence of noise may be reduced as compared with the case where quantum calculation is performed by the quantum circuit obtained by converting the two CCZ gates into the equivalent circuits 62.

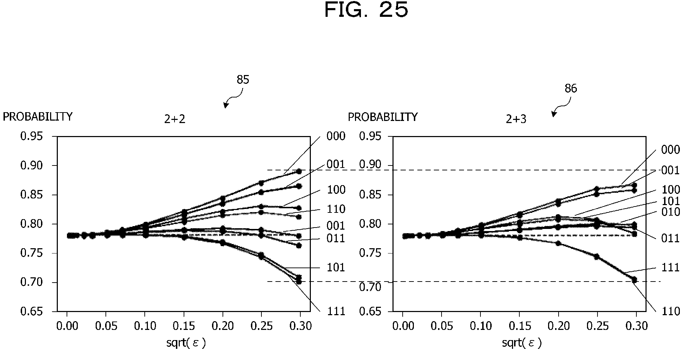

FIG. 25 is a diagram (part 3) illustrating an example of the relationship between the quantum calculation result and the noise. A graph 85 illustrates a simulation result of quantum calculation by a quantum circuit obtained by converting the two CCZ gates included in the Grover's algorithm with the three qubits into the equivalent circuits 63 while changing the noise amount of the gate operation. Furthermore, a graph 86 illustrates a simulation result of quantum calculation by a quantum circuit obtained by converting one of the two CCZ gates included in the Grover's algorithm with the three qubits into the equivalent circuit 63 and converting the other into the equivalent circuit 64 while changing the noise amount of the gate operation. Meanings of a vertical axis, a horizontal axis, and each line of each of the graphs 85 and 86 are similar to those of the graph 81. Note that, in the graph 86, a line indicating a result in a case where a correct answer is "111" and a line indicating a result in a case where the correct answer is "110" substantially overlap.

In the graph 86, a difference between the output probability with respect to the increase in the noise amount and the case where there is no noise is smaller than that in the graph 85. Therefore, the graphs 85 and 86 indicate that, when quantum calculation is performed by the quantum circuit obtained by converting one of the two CCZ gates into the equivalent circuit 63 and converting the other into the equivalent circuit 64, an influence of noise may be reduced as compared with the case where quantum calculation is performed by the quantum circuit obtained by converting the two CCZ gates into the equivalent circuits 63.

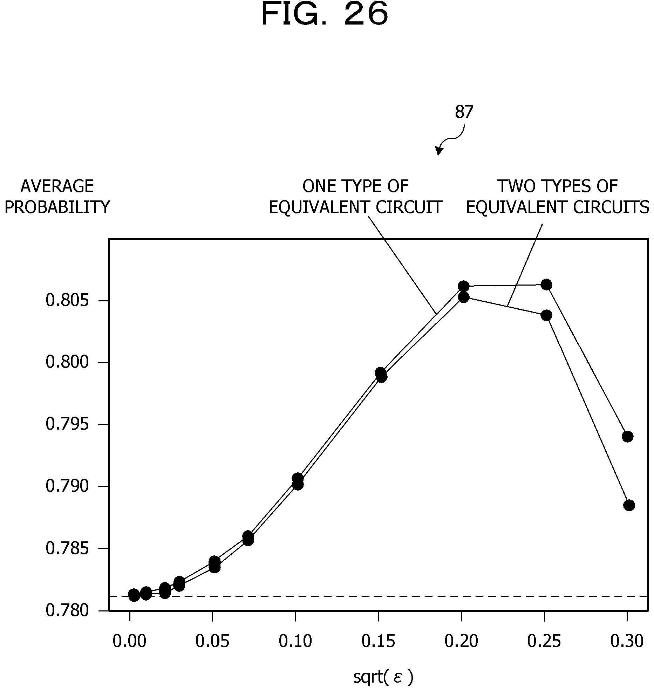

FIG. 26 is a diagram (part 4) illustrating an example of the relationship between the quantum calculation result and the noise. A graph 87 compares a difference between a case where the two CCZ gates included in the Grover's algorithm with the three qubits are converted into one type of equivalent circuit and a case where the two CCZ gates are converted into two types of equivalent circuits. A vertical axis of the graph 87 indicates an average of the probabilities (average probability) that the state corresponding to the correct answer data is output. A horizontal axis of the graph 87 indicates the noise amount included in the gate operation.

A line indicating a result in the case of one type of equivalent circuit in the graph 87 indicates a value obtained by averaging, for each noise amount, the output probabilities of the correct answer data corresponding to the noise amount, which are obtained for the respective correct answer values in a case where quantum calculation is performed using one type of equivalent circuit such as in the graphs 81, 83, and 85. A line indicating a result in the case of two types of equivalent circuits in the graph 87 indicates a value obtained by averaging, for each noise amount, the output probabilities of the correct answer data corresponding to the noise amount, which are obtained for the respective correct answer values in a case where quantum calculation is performed using two types of equivalent circuits constituting a set, such as in the graphs 82, 84, and 86.

As illustrated in the graph 87, in a case where the two CCZ gates are converted into two types of equivalent circuits, a difference between the average probability and the probability in a case where there is no noise is smaller than that in a case where the two CCZ gates are converted into one type of equivalent circuit.

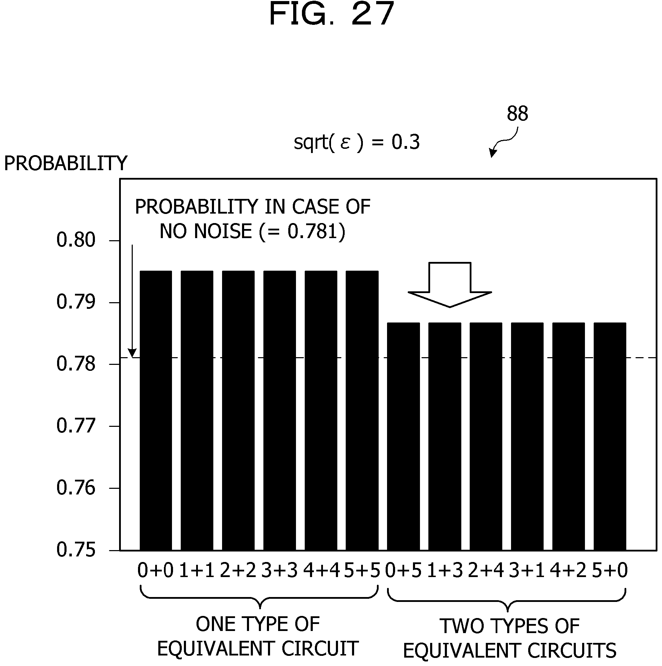

FIG. 27 is a diagram (part 5) illustrating an example of the relationship between the quantum calculation result and the noise. A graph 88 illustrates the output probability of the state corresponding to the correct answer data in the case of sqrt(s) = 0.3 in each quantum calculation used to generate the graph 87 illustrated in FIG. 26. The graph 88 illustrates the output probability in a case where quantum calculation by the quantum circuit obtained by converting the two CCZ gates included in the quantum circuit into the same equivalent circuit (one type of equivalent circuit) is executed with sqrt($\varepsilon$) = 0.3.

Furthermore, the graph 88 illustrates an output probability in a case where quantum calculation by the quantum circuit obtained by converting one of the two CCZ gates included in the quantum circuit into an equivalent circuit arranged by symmetrically moving each element of the other equivalent circuit up and down (two types of equivalent circuits) is executed with sqrt($\varepsilon$) = 0.3.

In the graph 88, for the two CCZ gates, the probability obtained in a case where the quantum calculation is executed by the quantum circuit converted into two types of equivalent circuits is a value closer to the probability in the case where there is no noise than a case where the quantum calculation is executed by the quantum circuit converted into one type of equivalent circuit. Therefore, the gate conversion unit 150 may reduce an error in quantum calculation by converting the two CCZ gates into two types of equivalent circuits.

Note that, in the above description, the Grover's algorithm with the three qubits has been described as an example, but the Grover's algorithm may also be executed with equal to or more than four qubits.

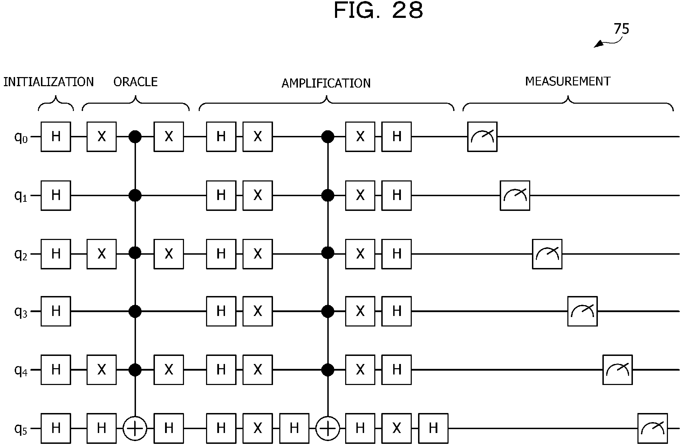

FIG. 28 is a diagram illustrating an example of a quantum circuit that executes the Grover's algorithm with six qubits. A quantum circuit 75 indicates order of operations for the respective qubits $q_0$, $q_1$, $q_2$, $q_3$, $q_4$, and $q_5$ in a case where the Grover's algorithm with the number of times of repetition of one is executed with the six qubits.

The H gate for each of the qubits $q_0$ to $q_5$ is arranged at a left end of the quantum circuit 75. As a first operation indicated by the quantum circuit 75, the H gate is acted on each of the qubits $q_0$ to $q_5$, so that the qubits $q_0$ to $q_5$ are in a superposed state (initialized). Furthermore, in the quantum circuit 75, a combination of the X gate, the H gate, and the CnNOT gate indicating processing of applying the oracle is arranged on the right side of the H gates indicating initialization. Furthermore, in the quantum circuit 75, a combination of the H gates, the X gates, and the CnNOT gate indicating the amplification processing is arranged on the right side of the combination of the gates indicating the oracle. Furthermore, in the quantum circuit 75, observation for each of the qubits $q_0$ to $q_5$ is arranged on the right side of the combination of the gates indicating the amplification processing. By the observation indicated in the quantum circuit 75, a result of performing the inversion amplification processing of the Grover's algorithm once with the six qubits is output.

The gate conversion unit 150 converts the CnNOT gate included in the quantum circuit 75 into a combination of the CCX gates and the CNOT gate, and converts the CCX gate into a combination of the CCZ gate and the H gates. Then, for example, the gate conversion unit 150 converts one of the two CCZ gates for the same combination of qubits converted from the CnNOT gate into the equivalent circuit 61, and converts the other into the equivalent circuit 66.

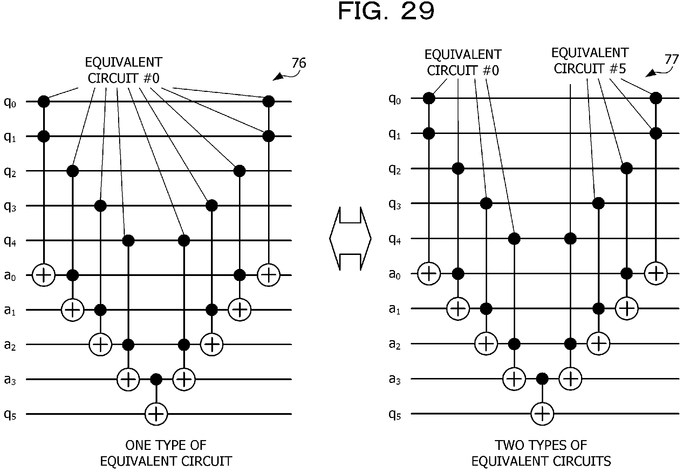

FIG. 29 is a diagram illustrating a conversion example of the CCX gate in an equivalent circuit of the C5NOT gate. An equivalent circuit 76 is an example in which each of the CCX gates in the equivalent circuit 73 (see FIG. 16) of the C5NOT gate is converted into the equivalent circuit 71 as illustrated in FIG. 15 using one type of CCZ gate (#0). On the other hand, an equivalent circuit 77 is an example in which the CCX gates in the equivalent circuit 73 (see FIG. 16) of the C5NOT gate are converted into the equivalent circuits 71 as illustrated in FIG. 15 using two types of CCZ gates (#0 and #5). For example, five CCX gates from a head of the equivalent circuit 77 are converted into the equivalent circuits 71 of the CCX gate as illustrated in FIG. 15 using the equivalent circuit 61 of "#0" of the CCZ gate. Furthermore, five CCX gates from a rear of the equivalent circuit 77 are converted into the equivalent circuits 71 of the CCX gate as illustrated in FIG. 15 using the equivalent circuit 66 of "#5" of the CCZ gate.

Next, a difference in probability of correct answer data between a case where the C5NOT gate is converted as in the equivalent circuit 76 and a case where the C5NOT gate is converted as in the equivalent circuit 77 in the quantum circuit that executes the Grover's algorithm with the six qubits will be described.

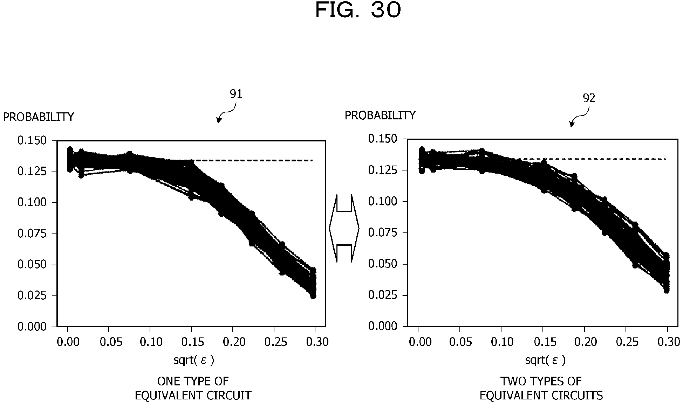

FIG. 30 is a diagram (part 6) illustrating an example of the relationship between the quantum calculation result and the noise. Graphs 91 and 92 illustrate simulation results of quantum calculation by the quantum circuit obtained by converting the C5NOT gate included in the Grover's algorithm with the six qubits while changing the noise amount of the gate operation. A vertical axis of each of the graphs 91 and 92 indicates an output probability of a state corresponding to the correct answer data in a case where the state corresponding to the correct answer data is each of "000000" to "111111". A horizontal axis of each of the graphs 91 and 92 indicates the noise amount included in the gate operation.

The graph 91 illustrates a simulation result of quantum calculation by a quantum circuit obtained by converting the two CCZ gates for the same combination of qubits converted from the C5NOT gate as in the equivalent circuit 76 illustrated in FIG. 29 (one type of equivalent circuit). Furthermore, the graph 92 illustrates a simulation result of quantum calculation by a quantum circuit obtained by converting the two CCZ gates for the same combination of qubits converted from the C5NOT gate as in the equivalent circuit 77 illustrated in FIG. 29 (two types of equivalent circuits).

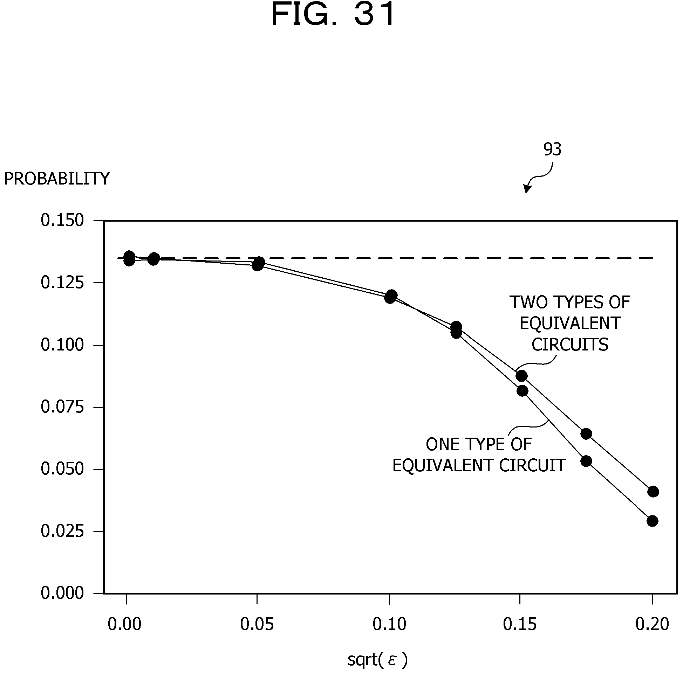

FIG. 31 is a diagram (part 7) illustrating an example of the relationship between the quantum calculation result and the noise. A vertical axis of a graph 93 indicates an average of the output probabilities of the state corresponding to the correct answer data in a case where the state corresponding to the correct answer data is each of "000000" to "111111". A horizontal axis of the graph 93 indicates the noise amount included in the gate operation.

One of lines illustrated in the graph 93 indicates an average of the output probabilities of the state corresponding to the correct answer data in a case where the state corresponding to the correct answer data illustrated in the graph 91 (one type of equivalent circuit) is each of "000000" to "111111". The other line indicates an average of the output probabilities of the state corresponding to the correct answer data in a case where the state corresponding to the correct answer data illustrated in the graph 92 (two types of equivalent circuits) is each of "000000" to "111111".

According to the graph 93, a decrease amount of the output probability is smaller in a case where the quantum calculation is executed by the quantum circuit obtained by converting the two CCZ gates into two types of equivalent circuits than in a case where the quantum calculation is executed by the quantum circuit obtained by converting the two CCZ gates into one type of equivalent circuit. That is, the graph 93 indicates that an influence of noise may be reduced more in a case where the quantum calculation is executed by the quantum circuit obtained by converting the two CCZ gates into two types of equivalent circuits than in a case where the quantum calculation is executed by the quantum circuit obtained by converting the two CCZ gates into one type of equivalent circuit.

As described above, even in quantum calculation executed by a quantum circuit including the CnNOT gate, the gate conversion unit 150 may reduce an error generated by an influence of noise included in a gate operation being biased to a specific qubit.

While the embodiments have been exemplified thus far, the configuration of each unit illustrated in the embodiments may be replaced with another configuration having a similar function. Furthermore, other optional components and steps may be added. Moreover, optional two or more configurations (features) of the embodiments described above may be combined.

The above description merely indicates a principle of the present invention. Moreover, numerous modifications and variations may be made by those skilled in the art, and the present invention is not limited to the above-described or illustrated exact configuration and application example, and all corresponding modifications and equivalents are regarded to fall within the scope of the present invention by appended claims and equivalents thereof.

REFERENCE SIGNS LIST

1 First quantum circuit
1a First element
1b Second element
2 First equivalent circuit
2a to 2e, 3a to 3e Two-qubit gate
3 Second equivalent circuit
10 Quantum circuit design device
11 Processing unit

**Claims**

1. A quantum circuit design program for causing a computer to execute processing comprising:

   detecting, from a first quantum circuit that is a quantum circuit that includes a plurality of elements and that indicates operation order on each of a plurality of qubits included in a quantum computer by arrangement of each of the plurality of elements in the quantum circuit, a first element that indicates a predetermined operation on a plurality of first qubits among the plurality of qubits and a second element that indicates the predetermined operation on the plurality of first qubits; and
   generating a second quantum circuit obtained by converting the first element of the first quantum circuit into a first equivalent circuit for ion operation that corresponds to the plurality of first qubits and converting the second element into a second equivalent circuit arranged by symmetrically moving elements of the first equivalent circuit in an arrangement direction of the plurality of first qubits.

2. The quantum circuit design program according to claim 1, wherein
   the first equivalent circuit includes a two-qubit gate that indicates a rotation operation of a predetermined angle on two of the plurality of first qubits.

3. The quantum circuit design program according to claim 1 or 2, wherein
   the predetermined operation is an operation of inverting a phase of one target bit among the plurality of first qubits according to two control bits among the plurality of first qubits.

4. The quantum circuit design program according to claim 3, wherein,
   in the processing of generating the second quantum circuit, a third element that inverts a bit of the one target bit among the plurality of first qubits according to the two control bits among the plurality of first qubits is converted into a third equivalent circuit that includes the predetermined operation.

5. The quantum circuit design program according to claim 4, wherein,
in the processing of generating the second quantum circuit, a fourth element that inverts, according to equal to or more than three control bits among a plurality of second qubits that includes the plurality of first qubits, a bit of one target bit among the plurality of second qubits is converted into a fourth equivalent circuit that includes the third element.

6. The quantum circuit design program according to any one of claims 1 to 5, wherein each of the first element and the second element is a quantum gate.

7. The quantum circuit design program according to claim 4, wherein the third element is a CCX gate.

8. The quantum circuit design program according to claim 5, wherein the fourth element is a CnNOT gate.

9. A quantum circuit design method comprising:

detecting, from a first quantum circuit that is a quantum circuit that includes a plurality of elements and that indicates operation order on each of a plurality of qubits included in a quantum computer by arrangement of each of the plurality of elements in the quantum circuit, a first element that indicates a predetermined operation on a plurality of first qubits among the plurality of qubits and a second element that indicates the predetermined operation on the plurality of first qubits; and
generating a second quantum circuit obtained by converting the first element of the first quantum circuit into a first equivalent circuit for ion operation that corresponds to the plurality of first qubits and converting the second element into a second equivalent circuit arranged by symmetrically moving elements of the first equivalent circuit in an arrangement direction of the plurality of first qubits.

10. A quantum circuit design device comprising:
a processing unit configured to detect, from a first quantum circuit that is a quantum circuit that includes a plurality of elements and that indicates operation order on each of a plurality of qubits included in a quantum computer by arrangement of each of the plurality of elements in the quantum circuit, a first element that indicates a predetermined operation on a plurality of first qubits among the plurality of qubits and a second element that indicates the predetermined operation on the plurality of first qubits; and generate a second quantum circuit obtained by converting the first element of the first quantum circuit into a first equivalent circuit for ion operation that corresponds to the plurality of first qubits and converting the second element into a second equivalent circuit arranged by symmetrically moving elements of the first equivalent circuit in an arrangement direction of the plurality of first qubits.

# FIG. 1

2a TO 2e, 3a TO 3e: TWO-QUBIT GATE (XX GATE)

# FIG. 2

# FIG. 3

100

101 CPU

104 GPU

21

22

102 RAM

105 INPUT INTERFACE

23

103 HDD

106 OPTICAL DRIVE DEVICE

24

109 NETWORK INTERFACE

107 DEVICE COUPLING INTERFACE

25

110

108 DEVICE COUPLING INTERFACE

26

27

20 NETWORK

200 QUBIT CONTROL DEVICE

# FIG. 4

PROBABILITY AMPLITUDE

$\dfrac{1}{\sqrt{N}}$

41

$X_1$  $X_2$  $X_3$  $X_4$   GROUND STATE

ORACLE

PROBABILITY AMPLITUDE

42

$X_1$  $X_2$  $X_3$  $X_4$   GROUND STATE

AMPLIFY

PROBABILITY AMPLITUDE

43

$X_1$  $X_2$  $X_3$  $X_4$   GROUND STATE

## FIG. 5

FIG. 6

CCZ GATE

# FIG. 7

$$CX = \begin{bmatrix} 1 & 0 & 0 & 0 \\ 0 & 1 & 0 & 0 \\ 0 & 0 & 0 & 1 \\ 0 & 0 & 1 & 0 \end{bmatrix}$$

$$XX(\chi) = \begin{bmatrix} \cos(\chi) & 0 & 0 & -i\sin(\chi) \\ 0 & \cos(\chi) & -i\sin(\chi) & 0 \\ 0 & -i\sin(\chi) & \cos(\chi) & 0 \\ -i\sin(\chi) & 0 & 0 & \cos(\chi) \end{bmatrix}$$

$$\chi = \frac{\pi}{4}$$

# FIG. 8

# FIG. 9

PROBABILITY IN CASE OF NO NOISE
(= 0.781)

# FIG. 10

# FIG. 11

| DETECTION GATE | EQUIVALENT CIRCUIT |
|---|---|
| 121 | |

FIG. 12

ARRANGEMENT OBTAINED BY
SYMMETRICAL MOVEMENT TO UP
AND DOWN

FIG. 13

CCZ GATE

FIG. 14

# FIG. 15

CCX GATE

# FIG. 16

## FIG. 17

# FIG. 18

```
        ┌────────────────────────┐
        │   QUANTUM CIRCUIT      │
        │     CONVERSION         │
        └────────────────────────┘
                    │
                    ▼
   ┌──────────────────────────────────────┐
   │      ACQUIRE QUANTUM CIRCUIT          │───S101
   └──────────────────────────────────────┘
                    │
                    ▼
   ┌──────────────────────────────────────┐
   │  CONVERT CnNOT GATE INTO COMBINATION OF │───S102
   │      CCX GATES AND CNOT GATE          │
   └──────────────────────────────────────┘
                    │
                    ▼
   ┌──────────────────────────────────────┐
   │  CONVERT CCX GATE INTO COMBINATION OF CCZ │───S103
   │        GATE AND H GATE                │
   └──────────────────────────────────────┘
                    │
                    ▼
   ┌──────────────────────────────────────┐
   │           DETECT CCZ GATE             │───S104
   └──────────────────────────────────────┘
                    │
                    ▼
              ◇ S105
      ╱─────────────────────────╲        NO
     ⟨    IS CCZ GATE DETECTED?   ⟩──────────┐
      ╲─────────────────────────╱           │
                    │ YES                     │
                    ▼                         │
   ┌──────────────────────────────────────┐  │
   │  PERFORM CONVERSION INTO EQUIVALENT   │  │
   │ CIRCUIT THAT IS COMBINATION OF OPERATIONS│───S106
   │          ON ONE OR TWO QUBITS         │  │
   └──────────────────────────────────────┘  │
                    │                         │
                    ▼                         │
   ┌──────────────────────────────────────┐  │
   │  DETECT CCZ GATE FOR SAME COMBINATION OF │───S107
   │               QUBITS                  │  │
   └──────────────────────────────────────┘  │
                    │                         │
                    ▼                         │
              ◇ S108                          │
   NO  ╱─────────────────────────╲           │
   ◄──⟨    IS CCZ GATE DETECTED?   ⟩          │
       ╲─────────────────────────╱           │
                    │ YES                     │
                    ▼                         │
   ┌──────────────────────────────────────┐  │
   │  PERFORM CONVERSION INTO EQUIVALENT   │  │
   │ CIRCUIT OBTAINED BY SYMMETRICALLY MOVING │───S109
   │             ELEMENTS                  │  │
   └──────────────────────────────────────┘  │
                    │                         │
                    ▼◄────────────────────────┘
   ┌──────────────────────────────────────┐
   │ CONTROL QUBIT CONTROL DEVICE ACCORDING│───S110
   │   TO QUANTUM CIRCUIT AFTER CONVERSION │
   └──────────────────────────────────────┘
                    │
                    ▼
               ┌─────────┐
               │   END   │
               └─────────┘
```

FIG. 19

# FIG. 20

# FIG. 21

# FIG. 22

FIG. 23

# FIG. 24

# FIG. 25

# FIG. 26

# FIG. 27

# FIG. 28

FIG. 29

EQUIVALENT
CIRCUIT #0                76

$q_0$
$q_1$
$q_2$
$q_3$
$q_4$
$a_0$
$a_1$
$a_2$
$a_3$
$q_5$

ONE TYPE OF
EQUIVALENT CIRCUIT

EQUIVALENT        EQUIVALENT
CIRCUIT #0        CIRCUIT #5        77

$q_0$
$q_1$
$q_2$
$q_3$
$q_4$
$a_0$
$a_1$
$a_2$
$a_3$
$q_5$

TWO TYPES OF
EQUIVALENT CIRCUITS

FIG. 30

PROBABILITY

91

ONE TYPE OF
EQUIVALENT CIRCUIT

PROBABILITY

92

TWO TYPES OF
EQUIVALENT CIRCUITS

# FIG. 31

## INTERNATIONAL SEARCH REPORT

| International application No. |
|---|
| **PCT/JP2021/048573** |

**A. CLASSIFICATION OF SUBJECT MATTER**

*G06N 10/00*(2022.01)i
FI: G06N10/00

According to International Patent Classification (IPC) or to both national classification and IPC

**B. FIELDS SEARCHED**

Minimum documentation searched (classification system followed by classification symbols)

G06N10/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | US 2021/0192113 A1 (UNIVERSITY OF MARYLAND, COLLEGE PARK) 24 June 2021 (2021-06-24)<br>entire text, all drawings | 1-10 |
| A | US 2020/0184024 A1 (IONQ, INC.) 11 June 2020 (2020-06-11)<br>entire text, all drawings | 1-10 |
| A | ITOKO, Toshinari et al. Optimization of Quantum Circuit Mapping using Gate Transformation and Commutation. arXiv.org [online]. 18 October 2019, [retrieval date 09 March 2022], Internet:<URL:https://arxiv.org/pdf/1907.02686.pdf><br>entire text, all drawings | 1-10 |

☐ Further documents are listed in the continuation of Box C.　　☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **09 March 2022** | **22 March 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**
Information on patent family members

International application No.

**PCT/JP2021/048573**

| Patent document cited in search report | | | Publication date (day/month/year) | Patent family member(s) | | | Publication date (day/month/year) |
|---|---|---|---|---|---|---|---|
| US | 2021/0192113 | A1 | 24 June 2021 | JP | 2021-503116 | A | |
| | | | | entire text, all drawings | | | |
| | | | | WO | 2019/079754 | A1 | |
| | | | | KR | 10-2020-0101333 | A | |
| | | | | CN | 111602151 | A | |
| US | 2020/0184024 | A1 | 11 June 2020 | WO | 2020/117552 | A1 | |
| | | | | entire text, all drawings | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021503116 A

- JP 2003526855 A

**Non-patent literature cited in the description**

- **DMITRI MASLOV**. Basic circuit compilation techniques for an ion-trap quantum Machine. *New Journal of Physics*, 19 February 2017